# EUROPÄISCHE PATENTSCHRIFT

(11) **EP 0 909 340 B1**
(45) Veröffentlichungstag und Bekanntmachung des Hinweises auf die Patenterteilung: **19.03.2003**
(21) Anmeldenummer: 97953621.6
(22) Anmeldetag: 08.12.1997
(51) Int. Cl.: C23C 14/22, C23C 14/02, C23C 14/08

(54) **SCHICHTMATERIAL SOWIE VORRICHTUNG UND VERFAHREN ZUM HERSTELLEN VON SCHICHTMATERIAL**
MULTILAYERED MATERIAL, PROCESS AND DEVICE FOR PRODUCING A MULTILAYERED MATERIAL
MATERIAU STRATIFIE, PROCEDE ET DISPOSITIF DE PRODUCTION DE MATERIAU STRATIFIE

(30) Priorität: 06.12.1996 DE 19650567; 05.06.1997 DE 19723573; 24.10.1997 EP 97118550; 24.10.1997 DE 29719004 U; 27.10.1997 EP 97118653; 21.11.1997 DE 29720733 U
(43) Veröffentlichungstag der Anmeldung: 21.04.1999
(73) Patentinhaber: Theva Dünnschichttechnik GmbH, 85354 Freising (DE)
(72) Erfinder: KINDER, Helmut, D-85354 Freising (DE); BAUER, Markus, D-85375 Neufahrn (DE); SCHWACHULLA, Joachim, D-81539 München (DE)
(74) Vertreter: Hess, Peter K., Dipl.-Phys.
(86) Internationale Anmeldenummer: DE9702868
(87) Internationale Veröffentlichungsnummer: WO98024944

(56) Entgegenhaltungen:
- US-A- 4 900 622
- US-A- 5 004 721
- PATENT ABSTRACTS OF JAPAN vol. 018, no. 445 (P-1789), 18.August 1994 -& JP 06 139541 A (KAO CORP), 20.Mai 1994,
- PATENT ABSTRACTS OF JAPAN vol. 006, no. 241 (P-158), 30.November 1982 -& JP 57 138058 A (MATSUSHITA DENKI SANGYO KK), 26.August 1982,
- GOYAL A ET AL: "HIGH CRITICAL CURRENT DENSITY SUPERCONDUCTING TAPES BY EPITAXIAL DEPOSITION OF YBA2CU3OX THICK FILMS ON BIAXIALLY TEXTURED METALS" APPLIED PHYSICS LETTERS, Bd. 69, Nr. 12, 16.September 1996, Seiten 1795-1797, XP000629182 in der Anmeldung erwähnt

## Beschreibung

Die Erfindung betrifft allgemein ein Schichtmaterial sowie eine Vorrichtung und ein Verfahren zum Herstellen eines Schichtmaterials. Genauer betrifft die Erfindung ein Schichtmaterial mit der Reihe nach einem amorphen oder polykristallinen Substrat, einer texturierten Pufferschicht und einer orientierten oxidischen Dünnschicht. Die Erfindung basiert ferner auf einer Vorrichtung zum Herstellen von Schichtmaterial nach dem Oberbegriff des Anspruchs 1 sowie einem Verfahren zum Herstellen von Schichtmaterial nach dem Oberbegriff des Anspruchs 9, wie ein Verfahren zur Herstellung von einkristallinen Dünnschichten auf polykristallinen oder amorphen Substraten.

Zur Herstellung von einkristallinen dünnen Schichten eines bestimmten Materials wird dieses im allgemeinen auf geeignete einkristalline Substrate eines anderen Materials aufgebracht. Die Substrate müssen dabei eine geeignete Gitterstruktur aufweisen, um die sogenannte Heteroepitaxie zu ermöglichen, bei der die einkristalline Struktur des Substrates von der aufgebrachten Schicht übernommen wird. Dieses Verfahren wird auch verwendet, um dünne Schichten hoher Qualität von z.B. oxidischen Hochtemperatursupraleitern wie z.B. YBa₂Cu₃O_{7-d} (YBCO) herzustellen. Bei solchen Supraleitern können Korngrenzen drastisch die supraleitenden Eigenschaften verschlechtern. Dabei wirken sich Korngrenzen mit einem großen Korngrenzenwinkel stärker aus als solche mit einem kleinen Winkel zwischen den Kristallachsen der beteiligten Körner. Der Effekt der Korngrenzen wird deutlich beim Vergleich der kritischen Stromdichten. Diese beträgt in YBCO bei 77K auf einkristallinen Substraten im Eigenmagnetfeld 3 bis 5 MA/cm². Auf untexturierten Substraten erreicht man typisch nur 0.02 MA/cm². Aus diesem Grund ist man bei der Herstellung von hochwertigen Hochtemperatursupraleiterschichten auf eine einkristalline Struktur des Supraleiters angewiesen.

Die Methode der Herstellung hochwertiger Supraleiterschichten durch heteroepitaktisches Wachstum auf einkristallinen Substraten ist auf relativ kleine Flächen begrenzt, da solche Substrate nur bis zu einer sehr begrenzten Größe zur Verfügung stehen. Zudem sind einkristalline Substrate sehr teuer und deshalb in vielen Fällen unwirtschaftlich. Ganz speziell ist es nicht möglich, Bänder aus Einkristallen herzustellen, welche die Voraussetzung für Stromkabel oder gewickelte Magneten aus Hochtemperatursupraleitern sind.

In jüngster Zeit wurden verschiedene Wege gegangen, um die Beschränkung auf Einkristalle zu umgehen. Dabei erzeugt man durch geeignete Verfahren in dem Substrat selbst oder in einer Pufferschicht, die auf das Substrat abgeschieden wird, eine quasi einkristalline oder insbesondere biaxiale Textur. Das bedeutet, daß die Kristallachsen des Substrates oder ggf. der Pufferschicht mit einer gewissen Unschärfe, die im allgemeinen durch eine oder mehrere Halbwertsbreiten charakterisiert wird, ausgerichtet sind. Auf dieses Substrat oder diese Pufferschicht wird dann in einem zweiten Schritt beispielsweise der Supraleiter heteroepitaktisch aufgebracht. Dadurch erreicht man beispielsweise verbesserte supraleitende Eigenschaften, wie z.B. die Erhöhung der kritischen Stromdichte. Diese ist um so größer, je kleiner die Halbwertsbreite oder die Halbwertsbreiten der Pufferschicht sind. Es wurden u.a. vier wesentliche Verfahren zur Erzeugung einer biaxialen Struktur veröffentlicht.

So wurde ein Verfahren entwickelt, bei dem man in Nickelbändern durch mehrfaches Walzen und anschließendes Rekristallisieren eine biaxiale Textur erzeugt (Rolling Assisted Biaxially Textured Substrates: RABiTS®), wie in A. Goyal et al., APL 69. Seite 1795, 1996. veröffentlicht wurde. Auf diese Nickelbänder kann ein Supraleiter aber nicht direkt aufgebracht werden, da Nickel aufgrund von Diffusions- und Oxidationsproblemen kein zur direkten Deposition des Supraleiters geeignetes Substrat darstellt. Deshalb wird durch eine komplizierte Schichtenfolge von epitaktisch darauf aufgewachsenen Pufferschichten eine Diffusionsbarriere und eine für die Supraleiterdeposition geeignete Oberfläche erzeugt, auf der dann die Hochtemperatursupraleiterschicht epitaktisch aufwächst. Bei diesem Verfahren ist nachteilig, daß Nickel aufgrund seiner mangelhaften Zugfestigkeit für viele Anwendungen ungeeignet ist. Nachteilig ist auch der Ferromagnetismus des Nickels bei Anwendungen im Magnetfeld.

Bei der sogenannten "Ion Beam Assisted Depositon" (IBAD; ionenstrahlunterstützte Deposition) nach Y. Iijama et al., APL 60, Seite 769, 1992, wird die Pufferschicht während ihrer Deposition auf ein beliebiges Substrat unter einem schrägen Winkel mit niederenergetischen Ionen beschossen. Als Pufferschichtmaterial wird dabei meist Y₂O₃ stabilisiertes Zirkondioxid (YSZ) verwendet. Mit diesem Verfahren lassen sich biaxial texturierte Schichten hoher Qualität herstellen, welche die Deposition von z.B. Supraleiterfilmen mit sehr guten Eigenschaften ermöglichen. Allerdings ist der apparative Aufwand durch die Verwendung einer Ionenquelle groß, die Depositionsrate niedrig und die Depositionsfläche durch die Ionenquelle begrenzt. Diese Punkte sind kostenintesiv und lassen das IBAD-Verfahren für eine kommerzielle Anwendung ungeeignet erscheinen.

Ein weiteres Verfahren ist die in K. Hasegawa et al., Proc. of ICEC 16, 1996, Kitakyushu, Japan, und EP 669 411 A2 offenbarte Laserdeposition unter schrägen Winkeln (Inclined Substrate Deposition: ISD). Je nach Depositonsbedingungen stellt sich bei der Laserdeposition auf ein nicht gekipptes Substrat eine Kristallachse senkrecht zur Substratoberfläche und damit parallel zur Depositionsrichtung. Kippt man nun die Substratnormale relativ zur Depositionsrichtung, folgt diese Kristallachse der Depositionsrichtung. Bei geeignetem Kippwinkel orientiert sich zusätzlich eine zweite Kristallachse parallel zur Oberfläche und man erhält die biaxiale Textur. Allerdings ist das Verfahren der Laserdeposition aufgrund der begrenzten simultan beschichtbaren Fläche weniger geeignet zur-kostengünstigen, großflächigen Beschichtung.

Auf eine ähnliche Weise wurden auch durch Aufdampfen von Aluminium aus resistiv geheizten Schiffchen eine biaxiale Textur in dünnen Metallschichten erzeugt (vgl. T. Hashimoto et al., Thin Solid Films 182, 197, 1989). Es wurde während der Deposition ein Hintergrundsdruck von 4x10⁻⁵ mbar verwendet. Der Grad der Texturierung war allerdings schlecht. Des weiteren sind Metalle im allgemeinen und Aluminium im speziellen aufgrund von Diffusions- und Oxidationsproblemen und aufgrund mangelnder thermischer Stabilität keine zur direkten Deposition des Supraleiters geeigneten Substratmaterialien.

Aus der US-5,004,721 ist ein Verfahren zur Herstellung einer Dünnschicht in Form eines oxidischen Supraleiterfilms durch Verdampfen bei einer Substrattemperatur oberhalb von 600C° bekannt. Dazu werden in einer Vakuumapparatur mit einer ersten und einer zweiten Kammer Vorläufersubstanzen für die Supraleitungsschicht mit Hilfe eines Elektronenstrahls oder durch Widerstandsheizer verdampft. Zur Oxidierung der Vorläufersubstanzen wird unmittelbar über der Substratoberfläche Sauerstoff zugeführt. Mit dieser Vorrichtung werden supraleitende Oxidfilme unmittelbar auf verschiedenen einkristallinen Oberflächen deponiert.

Zur Herstellung von magnetischen Schichten für Datenträger wird in der JP 06139541 die Deposition von drei magnetischen Schichten beschrieben, die jeweils kolumnare Strukturen mit unterschiedlichen Winkeln im Bezug auf die Normale aufweisen. Dadurch wird eine Vorzugsorientierung erreicht, deren Richtung sich in den einzelnen Schichten unterscheidet. Ein weiteres Schichtenensemble für ein Magnetband ist aus der US-4,900,622 bekannt, bei der auf einen dünnen Plastikfilm aus Polyester, Polyamid oder Polyimid zumindest zwei ferromagnetische Metallschichten aufgebracht werden, die vorzugsweise aus kolumnaren Kristallstrukturen bestehen, die unter einem Winkel in Bezug auf einer Normale zur Oberfläche des Substrats ausgerichtet sind, um bessere elektromagnetische Eigenschaften zu erzielen. Durch die separate Herstellung der einzelnen magnetischen Schichten kann die Orientierung der kolumnaren Kristallpartikel von einer zur anderen Schicht variieren, wobei die gewünschte Ausrichtung dieser Partikel durch schräges Aufdampfen auf das Kunststoffsubstrat aus einer Verdampferquelle unter Vakuumbedingungen erreicht wird.

Die vorliegende Erfindung hat zum Ziel, ein gegenüber dem Stand der Technik verbessertes Schichtsystem sowie verfahrensmäßige Verbesserungen bei der Herstellung eines Schichtsystems zu erreichen.

Dieses Ziel wird durch ein Schichtsystem nach Anspruch 1 und durch ein Verfahren nach Anspruch 9 erreicht.

Mit der mindestens einen Deckschicht nach der Erfindung wird erreicht, daß herstellungsbedingte Lücken und Unebenheiten in der Pufferschicht ausgeglichen werden, so daß die orientierte oxidische Dünnschicht entsprechend der für ihr Aufwachsen zur Verfügung stehenden Oberfläche der Deckschicht eine hohe Qualität hat, die sich insbesondere in einer hohen kritischen Stromdichte ausdrückt, wenn es sich bei der orientierten Dunnschicht um eine oxidische Hochtemperatursupraleiter-Dünnschicht handelt. Aber auch für andere entsprechende Dünnschichten werden durch die Erfindung qualitativ verbesserte Schichtaufbauten erreicht.

Soweit vor- und nachstehend auf Hochtemperatursupraleiter Bezug genommen wird, ist dies nur exemplarisch zu verstehen. Ohne Einschränkungen eignet sich die Erfindung allgemein auch für jegliche andere orientierte, vorzugsweise oxidische oder metallische Dünnschicht, die insbesondere eine technische Funktionsschicht sein kann, wie neben einer bereits erwähnten Hochtemperatursupraleiterschicht, beispielsweise einer YBCO-Schicht, eine ferromagnetische Schicht, einschließlich eine solche ferromagnetische Schicht mit sog. "Giant Magneto Resistance", oder eine ferroelektrische Schicht. Als weitere Möglichkeit kann eine Mehrzahl von orientierten Dünnschichten übereinander über der wenigstens einen Deckschicht liegen.

Bevorzugt ist es, wenn das Material für die Pufferschicht unter einem Winkel α₁ ≠ 0 zur Normalen auf der Substratoberfläche auf letztere aufgedampft wurde, und wenn vorzugsweise ferner das Material für die Deckschicht unter Depositionsbedingungen, die verschieden sind von denen sind, unter denen die Pufferschicht aufgebracht wurde, insbesondere unter anderem Druck, anderer Temperatur, anderer Rate und/oder anderem Winkel α₂ ≠ α₁, vorzugsweise α₂ < α₁, bevorzugt α₂ ≈ 0°, zur Normalen auf der Substratoberfläche, auf die Pufferschicht aufgedampft wurde. Gemäß weiteren vorzugsweisen Ausgestaltungen kann die Pufferschicht eine biaxiale Textur und/oder eine Facettierung aufweisen.

Vorzugsweise Materialien für die Pufferschichtund/oder wenigstens eine Deckschicht enthalten Oxidmaterial, einschließlich MgO, CeO₂, Y₂O₃ stabilisiertes Zirkonoxid (YSZ). Weiterhin kann vorgesehen sein, daß das Substrat eine der orientierten Dünnschicht zugewandte, insbesondere polierte und/oder hitzebeständige Metall- oder Metallegierungsoberfläche mit amorpher oder polykristalliner Struktur aufweist, wobei insbesondere das Substrat selbst und/oder die Oberfläche thermisch oxidiertes Silizium, eine Nickelbasislegierung, wie Hastelloy C®, partiell Y₂O₃ stabilisiertes ZrO₂ (PSZ), hitzebeständigen Edelstahl. Platin und/oder Al₂O₃, jeweils in polykristalliner oder amorpher Form, enthalten/enthält. Beispielsweise kann eine untexturierte Al₂O₃-Schicht die Oberfläche des Substrates bilden, wodurch eine Art Schutzschicht geschaffen wird. Damit kann z.B. eine Diffusionssperrschicht, inklusive einer Oxidationssperrschicht, eine Glättungsschicht und/oder eine Schicht mit einem Haftvermittler in vorteilhafter Weise realisiert werden.

Bei einer Vorrichtung zum Herstellen von Schichtmaterial, mit einer Vakuumkammer, in der Positioniereinrichtungen für ein Substrat und Pufferschichtmaterialabgabeeinrichtungen zum Bilden einer Pufferschicht als Unterlage für eine orientierte oxidische Dünnschicht auf dem Substrat so angeordnet sind, daß Pufferschichtmaterial von den Pufferschichtmaterialabgabeeinrichtungen unter einem Winkel α₁ ≠ 0 zur Normalen auf der Substratoberfläche auf letztere aufdampfbar ist, wobei eine solche Vorrichtung nachfolgend als gattungsgemäß bezeichnet wird, kann das Ziel der Erfindung dadurch erreicht werden, daß Deckschichtmaterialabgabeeinrichtungen zum Bilden mindestens einer Deckschicht als Unterlage für die orientierte Dünnschicht auf der Pufferschicht und Einrichtungen vorgesehen sind, mittels denen das Materiat für die Deckschicht unter Depositionsbedingungen, die verschieden sind von denen, unter denen die Pufferschicht aufgebracht wurde, insbesondere unter anderem Druck, anderer Temperatur, anderer Rate und/oder anderem Winkel, auf die Pufferschicht aufdampfbar ist, wobei ggf. insbesondere Deckschichtmaterialabgabeeinrichtungen relativ zu den Substratpositioniereinrichtungen so angeordnet sind, daß Deckschichtmaterial unter einem Winkel α₂ ≠ α₁, insbesondere α₂ < α₁, vorzugsweise α₂ ≈ 0°, zur Substratoberflächennormalen auf der Pufferschicht aufbringbar ist.

Weitere vorrichtungsmäßige Realisierungen der Erfindung können alternativ oder zusätzlich zur vorstehenden Ausgestaltung Einrichtungen zum thermischen Verdampfen, insbesondere Elektronenstrahlverdampfen, oder reaktiven Verdampfen des Pufferschichtmaterials, ggf. des Deckschichtmaterials und/oder des Materials für die orientierte Dünnschicht enthalten.

Zur Erreichung des der Erfindung zu Grunde liegenden Ziels kann ferner zusammen mit jeder der vorstehenden Ausgestaltungen oder alleine eine gattungsgemäße Vorrichtung derart weitergebildet werden, daß der Winkel α₁ größer, insbesondere geringfügig größer als ein Winkel β ist, den eine Kristallachse des Pufferschichtmaterials mit der Substratoberflächennormalen einschließt, wobei eine weitere Kristallachse des Pufferschichtmaterials parallel zur Substratoberfläche ist.

Ebenfalls geeignet zur Erreichung des Ziels der Erfindung ist eine andere Fortbildung der gattungsgemäßen Vorrichtung, wobei im Bereich des Aufbringens des Pufferschichtmaterials, ggf. des Deckschichtmaterials und/oder des Materials für die orientierte oxidische Dünnschicht auf der jeweiligen Unterlage Einrichtungen zum Erzeugen und Aufrechterhalten eines im Vergleich zur übrigen Vakuumkammer höheren Druckes vorgesehen sind. Diese Merkmale können ggf. mit den vorstehenden Varianten kombiniert werden.

Statt oder zusätzlich zu oder im Rahmen der vorgenannten Drucküberhöhung können reaktive Materialien oder Komponenten, wie Radikale, Ionen, reaktivere Molekülverbindungen, als im Aufdampfmaterial vorhanden oder erwünscht, in einem Schichtbildungsbereich vorhanden sein.

Die reine Drucküberhöhung kann wegen der damit verbundenen Bereitstellung einer großen Anzahl allgemein als quantitativer Lösungsansatz, und die reine Verwendung reaktiver Materialien oder Komponenten kann wegen der Bereitstellung aktiver Teilchen als qualitativer Lösungsansatz angesehen werden.

Bei einer Vorrichtung entsprechend der weiter oben definierten Gattung kann das Ziel der Erfindung ferner alternativ oder zusätzlich dadurch erreicht werden, daß im Bereich des Aufbringens des Pufferschichtmaterials, ggf. des Deckschichtmaterials und/oder des Materials für die orientierte oxidische Dünnschicht auf der jeweiligen Unterlage Einrichtungen zum Zuführen von beim Verdampfen des jeweiligen Materials/der jeweiligen Materialien flüchtigen Komponenten und/oder zur Erzeugung der Pufferschicht, ggf. Deckschicht und/oder orientierten oxidischen Dünnschicht erforderlichen Komponenten und/oder reaktive Komponenten in Gasform vorgesehen sind. Eine solche Materialzuleitung erfolgt insbesondere mittels eines o.g. Drucküberhöhungsbereiches. Dabei können neben oder statt dem Ersatz von beim Verdampfen flüchtigen Stoffen auch Stoffe verwendet werden, mittels denen ein reaktives Verdampfen erreicht wird. Beispielsweise kann ein reines Metall verdampft werden und Sauerstoff im Rahmen der Drucküberhöhung zugefügt werden, so daß eine Oxidschicht gebildet wird. Als ein weiteres Beispiel kann H₂ zugegeben werden, um bevorzugte Wachstumsrichtungen zu ändern. Allgemein ausgedrückt kann ein Surfactant zugeführt werden.

Weiterbildungen der vorstehend angegebenen erfindungsgemäßen Vorrichtungen können umfassen:
I. daß ggf. die Substratpositioniereinrichtungen dazu ausgelegt sind, daß das Substrat zumindest in einem ersten Schichtbildungsbereich (a) so gegenüber der Horizontalen schräg angeordnet ist, daß Pufferschichtmaterial, das wenigstens ungefähr senkrecht zur Horizontalen von den Pufferschichtmaterialabgabeeinrichtungen aufsteigt, in dem ersten Schichtbildungsbereich unter einem Winkel α₁ ≠ 0 zur Normalen auf der Substratoberfläche auf das Substrat gelangt. oder (b) wenigstens annähernd parallel zur Horizontalen angeordnet ist, und die Pufferschichtmaterialabgabeeinrichtungen relativ zum ersten Schichtbildungsbereich so angeordnet sind, daß Pufferschichtmaterial, das schräg zur Horizontalen von den Pufferschichtmaterialabgabeeinrichtungen aufsteigt, in dem ersten Schichtbildungsbereich unter einem Winkel α₁ ≠ 0 zur Normalen auf der Substratoberfläche auf das Substrat gelangt, und/oder
II. daß ggf. die Substratpositioniereinrichtungen dazu ausgelegt sind, daß das Substrat mit Pufferschicht zumindest in einem zweiten Schichtbildungsbereich (a) so gegenüber der Horizontalen schräg angeordnet ist, daß Deckschichtmaterial, das wenigstens ungefähr senkrecht zur Horizontalen von Deckschichtmaterialabgabeeinrichtungen aufsteigt, in dem zweiten Schichtbildungsbereich wenigstens annähernd unter dem Winkel α₂, bevorzugt α₂ ≠ α₁, insbesondere α₂ < α₁, vorzugsweise α₂ ≈ 0°, zur Normalen auf der Substratoberfläche auf die Pufferschicht auf dem Substrat gelangt, oder (b) wenigstens annähernd parallel zur Horizontalen angeordnet ist, und die Deckschichtmaterialabgabeeinrichtungen so angeordnet sind, und die Deckschichtmaterialabgabeeinrichtungen relativ zum zweiten Schichtbildungsbereich so angeordnet sind, daß Deckschichtmaterial, das schräg zur Horizontalen von den Deckschichtmaterialabgabeeinrichtungen aufsteigt in dem zweiten Schichtbildungsbereich wenigstens ungefähr unter dem Winkel α₂, bevorzugt α₂ ≠ α₁, insbesondere α₂ < α₁, vorzugsweise α₂ ≈ 0°, zur Normalen auf der Substratoberfläche auf die Pufferschicht auf dem Substrat gelangt.

Bei anderen vorteilhaften Weiterbildungen der Erfindung kann vorgesehen sein, daß die Substratpositioniereinrichtungen eine Substrathalterung für daran bewegliche Substrate und/oder eine Substratführung für band- oder kabelförmig kontinuierlich geförderte Substrate enthält.

Insbesondere können ggf. die Einrichtungen zum Erzeugen und Aufrechterhalten eines im Vergleich zur übrigen Vakuumkammer höheren Druckes so angeordnet sein, um in einem Schichtbildungsbereich oder in einem Bereich mit bereits gebildeter Schicht oder Teilschicht einen gegenüber der übrigen Vakuumkammer erhöhten Druck aufrechtzuerhalten, wobei ggf. insbesondere ein mehrfaches Durchlaufen einer Drucküberhöhungseinrichtung und/oder nacheinander ein Durchlaufen von mehreren Drucküberhöhungseinrichtungen mit dazwischenliegenden Aufdampfstationen vorgesehen ist.

Ferner ist es bevorzugt, wenn ggf. die Drucküberhöhungseinrichtung dazu ausgelegt sind, in einem Schichtbildungsbereich oder in einem Bereich mit bereits gebildeter Schicht oder Teilschicht einen Druck von zumindest annähernd ≥ 5 x 10⁻⁴ mbar, insbesondere wenigstens etwa ≥ 1 x 10⁻³ mbar gegenüber einem Druck von annähernd etwa ≤ 1 x 10⁻⁴ mbar, vorzugsweise ≤ 2 x 10⁻⁵ mbar an der Quelle bereitzustellen.

Vorzugsweise sind die vorstehenden Vorrichtungen zum Herstellen von erfindungsgemäßem Schichtmaterial ausgelegt.

Das durch die Erfindung geschaffene Verfahren basiert auf den Schritten Aufbringen einer Pufferschicht auf ein Substrat, indem Pufferschichtmaterial von Pufferschichtmaterialabgabeeinrichtungen unter einem Winkel α₁ ≠ 0 zur Normalen auf der Substratoberfläche auf letztere aufgedampft wird, und danach Aufdampfen einer orientierten Dünnschicht darauf.

Auf dieser Basis wird erfindungsgemäß nach dem nach dem Aufdampfen der Pufferschicht und vor dem Aufdampfen der orientierten Dünnschicht zumindest eine Deckschicht unter Depositionsbedingungen, die verschieden sind von denen sind, unter denen die Pufferschicht aufgebracht wurde, insbesondere unter anderem Druck, anderer Temperatur, anderer Rate und/oder anderem Winkel α₂ ≠ α₁, vorzugsweise α₂ < α₁, bevorzugt α₂ ≈ 0°, zur Substratoberflächennormalen, und/oder so auf die Pufferschicht aufgedampft wird, daß die Pufferschicht eine biaxiale Textur und/oder eine Facettierung aufweist

Alternativ oder zusätzlich kann das Pufferschichtmaterial, das Deckschichtmaterial und/oder das Material für die orientierte oxidische Dünnschicht zum Aufbringen auf die jeweilige Unterlage thermisch verdampft, wie beispielsweise durch Elektronenstrahlverdampfen, oder reaktiv aufgebracht werden.

Weitere Varianten zur Erreichung des Ziels der Erfindung bestehen darin, daß der Winkel α₁ größer, insbesondere geringfügig größer als ein Winkel β ist, den eine Kristallachse des Pufferschichtmaterials mit der Substratoberflächennormalen einschließt, wobei eine weitere Kristallachse des Pufferschichtmaterials parallel zur Substratoberfläche ist.

Außerdem kann das erfindungsgemäße Verfahren zusätzlich zu den Basisschritten enthalten, daß im Bereich des Aufbringens des Pufferschichtmaterials, ggf. des Deckschichtmaterials und/oder des Materials für die orientierte oxidische Dünnschicht auf der jeweiligen Unterlage ein im Vergleich zu den übrigen Vakuumbedingungen höheren Druck vorliegt.

Schließlich ist es auch möglich, das Ziel der Erfindung zu erreichen, indem im Bereich des Aufbringens des Pufferschichtmaterials, ggf. des Deckschichtmaterials und/oder des Materials für die orientierte oxidische Dünnschicht auf der jeweiligen Unterlage beim Verdampfen des jeweiligen Materials/der jeweiligen Materialien flüchtige Komponenten und/oder zur Erzeugung der Pufferschicht, ggf. Deckschicht und/oder orientierten oxidischen Dünnschicht erforderliche Komponenten und/oder reaktive Komponenten in Gasform zugeführt werden/wird.

Hinsichtlich der Drucküberhöhung und/oder dem Vorhandensein bestimmter Materialien oder Teilchen im Schichtbildungsbereich wird bezüglich der Möglichkeiten und Wirkungen auf die entsprechenden Angaben weiter oben bei der Beschreibung der entsprechenden Vorrichtungsmerkmale verwiesen.

Die genannten Verfahren können dadurch weitergebildet werden, daß die orientierte Dünnschicht eine oxidische oder metallische Dünnschicht und/oder eine technische Funktionsschicht ist, wie insbesondere eine Hochtemperatursupraleiterschicht, vorzugsweise eine YBCO-Schicht, eine ferromagnetische Schicht, einschließlich eine solche ferromagnetische Schicht mit sog. "Giant Magneto Resistance", oder eine ferroelektrische Schicht, und daß bevorzugt eine Mehrzahl von orientierten Dünnschichten übereinander über der wenigstens einen Deckschicht aufgebracht wird.

Andere Fortbildungen des Verfahrens sehen vor, daß die Pufferschichtund/oder wenigstens eine Deckschicht Oxidmaterial, einschließlich MgO, CeO₂, Y₂O₃ stabilisiertes Zirkonoxid (YSZ), enthalten/enthält oder zumindest weitgehend aus diesen Materialien bestehen/besteht, und/oder daß das Substrat eine der orientierten Dünnschicht zugewandte, insbesondere polierte und/oder hitzebeständige Metall- oder Metallegierungsoberfläche mit amorpher oder polykristalliner Struktur aufweist, wobei vorzugsweise das Substrat selbst und/oder die Oberfläche thermisch oxidiertes Silizium, eine Nickelbasislegierung, wie Hastelloy C®, partiell Y₂O₃ stabilisiertes ZrO₂ (PSZ), hitzebeständigen Edelstahl, Platin und/oder Al₂O₃, jeweils in polykristalliner oder amorpher Form, enthalten/enthält.

Mögliche Weiterbildungen der vorstehenden Verfahren können darin bestehen, daß zum einen das Substrat zumindest in einem ersten Schichtbildungsbereich (a) so gegenüber der Horizontalen schräg angeordnet wird, daß Pufferschichtmaterial, das wenigstens ungefähr senkrecht zur Horizontalen von Pufferschichtmaterialabgabeeinrichtungen aufsteigt, in dem ersten Schichtbildungsbereich unter einem Winkel α₁ ≠ 0 zur Normalen auf der Substratoberfläche auf das Substrat gelangt, oder (b) wenigstens annähernd parallel zur Horizontalen angeordnet wird und Pufferschichtmaterial relativ zum ersten Schichtbildungsbereich so aufgedampft wird, daß Pufferschichtmaterial, das schräg zur Horizontalen von Pufferschichtmaterialabgabeeinrichtungen aufsteigt, in dem ersten Schichtbildungsbereich unter einem Winkel α₁ ≠ 0 zur Normalen auf der Substratoberfläche auf das Substrat gelangt, und/oder daß zum anderen das Substrat mit Pufferschicht zumindest in einem zweiten Schichtbildungsbereich (a) so gegenüber der Horizontalen schräg angeordnet wird, daß Deckschichtmaterial, das wenigstens ungefähr senkrecht zur Horizontalen von Deckschichtmaterialabgabeeinrichtungen aufsteigt, in dem zweiten Schichtbildungsbereich wenigstens annähernd unter dem Winkel α₂, bevorzugt α₂ ≠ α₁, insbesondere α₂ < α₁, vorzugsweise α₂ ≈ 0°, zur Normalen auf der Substratoberfläche auf die Pufferschicht auf dem Substrat gelangt, oder (b) wenigstens annähernd parallel zur Horizontalen angeordnet wird und Deckschichtmaterial relativ zum zweiten Schichtbildungsbereich so aufgedampft wird, daß Deckschichtmaterial, das schräg zur Horizontalen von den Deckschichtmaterialabgabeeinrichtungen aufsteigt, in dem zweiten Schichtbildungsbereich wenigstens ungefähr unter dem Winkel α₂, bevorzugt α₂ ≠ α₁, insbesondere α₂ < α₁, vorzugsweise α₂ ≈ 0°, zur Normalen auf der Substratoberfläche auf die Pufferschicht auf dem Substrat gelangt.

Weiterhin ist es bei dem Verfahren nach der Erfindung möglich, daß insbesondere band- oder kabelförmiges Substratmaterial kontinuierlich gefördert wird, oder daß ein Substrat beweglich angeordnet ist.

Es kann im Rahmen der Erfindung auch vorgesehen sein, daß ggf. in einem Schichtbildungsbereich oder in einem Bereich mit bereits gebildeter Schicht oder Teilschicht ein gegenüber den übrigen Vakuumbedingungen erhöhter Druck erzeugt oder aufrechterhalten wird, wobei insbesondere ein mehrfaches Durchlaufen einer Drucküberhöhungseinrichtung und/oder nacheinander ein Durchlaufen von mehreren Drucküberhöhungseinrichtungen mit dazwischenliegenden Aufdampfstationen erfolgt.

Weitere Alternativen oder Kombinationen zu bzw. mit vorstehenden Varianten können bei einem erfindungsgemäßen Verfahren dadurch erreicht werden, daß ggf. in einem Schichtbildungsbereich oder in einem Bereich mit bereits gebildeter Schicht oder Teilschicht ein Druck von zumindest annähernd ≥ 5 x 10⁻⁴ mbar, insbesondere wenigstens etwa ≥ 1 x 10⁻³ mbar gegenüber einem Druck von annähernd etwa ≤ 1 x 10⁻⁴ mbar, vorzugsweise ≤ 2 x 10⁻⁵ mbar an der Quelle bereitgestellt wird.

Vorzugsweise dienen die Verfahren nach der Erfindung zur Herstellung von eingangs angegebenen Schichtmaterial.

Bei dem Schichtmaterial sowie der Herstellungsvorrichtung und dem Herstellungsverfahren für Schichtmaterial wird eine einfache und schnelle, d.h. kostengünstige Herstellung von texturierten Pufferschichten für die Supraleiterbeschichtung ermöglicht. Zudem können die Puffer- und Deckschichten auch großflächig und kontinuierlich aufgebracht werden. Des weiteren kann die Textur einer biaxial texturierten Oberfläche auf den Supraleiter übertragen werden.

Weitere vorteilhafte und bevorzugte Ausgestaltungen der Erfindung ergeben sich aus den Ansprüchen und deren Kombinationen.

Die Erfindung wird nachfolgend unter Bezugnahme auf die Zeichnung anhand von Ausführungsbeispielen näher erläutert. In den Zeichnungen zeigen:
Fig. 1 schematisch eine Anordnung zur Methode des schrägen Aufdampfens,
Fig. 2 eine Orientierung von MgO-Schichten, die durch schräges Bedampfen hergestellt wurden,
Fig. 3 eine Orientierung von CeO₂-Schichten, die durch schräges Bedampfen hergestellt wurden,
Fig. 4 schematisch eine Anordnung zur Beschichtung auf ein bewegtes Substrat,
Fig. 5 ein Schema einer Anordnung zum simultanen Aufbringen mehrerer Schichten auf ein Band mit einer Quelle,
Fig. 6 die Intensität der (111), (200), (220) Röntgenbeugungsreflexe von CeO₂-Schichten, die senkrecht bei verschiedenen Substrattemperaturen aufgedampft wurden,
Fig. 7 ein Schema einer betrachteten Ausgangslage bei der Deposition auf unterschiedlich verkippte Kristalle,
Fig. 8 schematisch die Situation von Fig. 7 nach einer gewissen Depositionsdauer,
Fig. 9 eine schematische Darstellung einer Ausgangssituation mit unterschiedlich gekippten Kristallen,
Fig. 10 die Wirkung einer Abscheidung über eine gewisse Dauer auf die Ausgangssituation von Fig. 9 im Schema,
Fig. 11 eine schematische Querschnittsansicht eines Teils eines Schichtmaterials,
Fig. 12 eine REM-Aufnahme einer Deckschicht aus MgO,
Fig. 13 eine REM-Aufnahme einer YBCO-Schicht auf der Deckschicht von Fig. 12,
Fig. 14 eine Polfigur der in der Fig. 13 dargestellten YBCO-Schicht, und
Fig. 15 eine REM-Aufnahme einer YBCO-Schicht direkt auf einer Pufferschicht.

Zur Deposition der Schichten wird in einer Vakuumanlage die Methode des thermischen Verdampfens im allgemeinen verwendet. Bei dem thermischen Verdampfen wird das Verdampfungsmaterial durch Erhitzen verdampft. Das Erhitzen wird z.B. dadurch erreicht, daß ein sogenanntes Schiffchen durch elektrischen Strom resistiv beheizt wird. Das Verdampfungsmaterial, das in dem Schiffchen liegt wird dadurch soweit erhitzt, daß es verdampft.

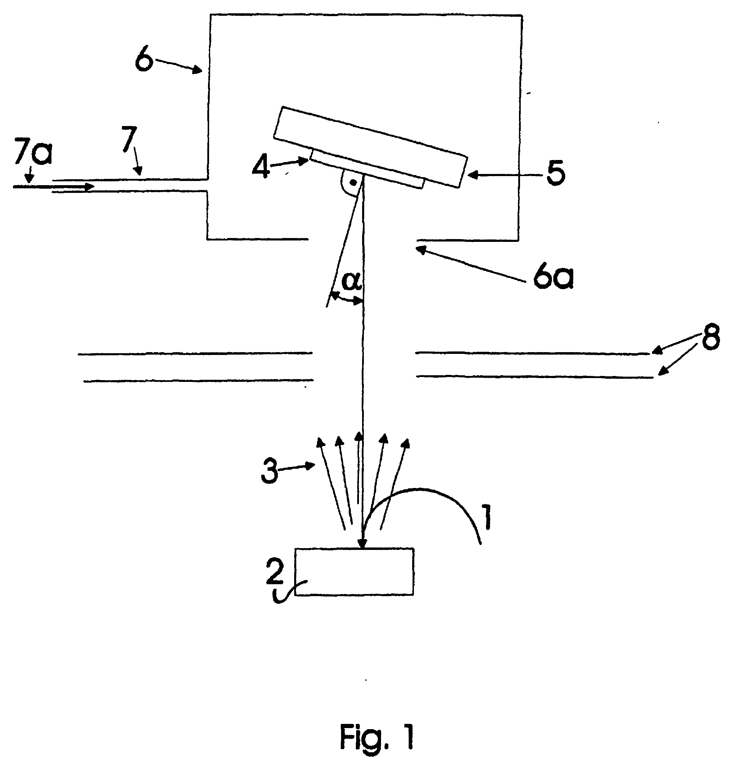

Ein anderes Verfahren des thermischen Verdampfens ist die Elektronenstrahlverdampfung, die im folgenden ohne Beschränkung der Allgemeinheit beschrieben wird (siehe Fig.1). Dazu wird in einer Vakuumkammer (nicht gezeigt) ein hochenergetischer Elektronenstrahl 1 auf das Verdampfungsmaterial (Target) 2 geschossen, wodurch dieses erhitzt wird und verdampft, wie durch die Pfeile 3 verdeutlicht ist. Als Verdampfungsmaterialien können reine Metalle oder Verbindungen verwendet werden. Im speziellen Beispiel werden MgO oder CeO₂ als Targetmaterial verwendet. Das zu bedampfende Substrat 4 ist über dem Target 2 angebracht und kann mittels eines Heizers 5 auf die erforderlichen Temperaturen gebracht werden. Ohne Beschränkung der Allgemeinheit ist in der Fig. 1 als Heizer 5 ein Block dargestellt, auf den das Substrat 4 geklemmt ist und der auf die erforderliche Temperatur aufgeheizt wird. Es sind auch andere Anordnungen möglich, wie z.B. eine-indirekte Strahlungsheizung. Statt einer Heizung kann ferner zur Kühlung des Substrates und entsprechenden Beeinflussung der Depositionsbedingungen eine Kühlung vorgesehen sein.

Das Substrat 4 ist so befestigt, daß die Substratnormale und die Verbindungslinie zwischen dem Substrat 4 und dem Target 2 einen Winkelα einschließen. Der Winkel α steht dabei entweder für den Winkel α₁, unter dem Pufferschichtmaterial aufgedampft wird, oder für den Winkel α₂, unter dem Deckschichtmaterial aufgedampft wird.

Die Anordnung hat somit allgemein zur Folge, daß das verdampfte Material unter ungefähr einem Winkel α auf die Oberfläche trifft. Da der Auftreffwinkel des verdampften Puffermaterials auf die Oberfläche die weiter unten beschriebene biaxiale Textur bewirkt, muß das Substrat nicht, wie in Fig. 1 gezeichnet ist, vertikal direkt über dem Target angebracht sein, sondern kann auch seitlich versetzt angeordnet werden.

Es kann Gas in der Nähe des Substrates 4 eingelassen werden. Bei der Deposition von Oxiden kann z.B. Sauerstoff als reaktives Gas eingelassen werden, um die gewünschte Oxitationsstufe zu erhalten oder es kann bei der Verdampfung des reinen Metalls vom Target 2 durch Zugabe von Sauerstoff am Substrat 4 eine Metalloxidschicht hergestellt werden.

Der für die Schichtherstellung notwendige Druck am Substrat 4 von ca. 1x10⁻³ mbar ist so groß, daß beim Einlaß einer entsprechenden Gasmenge als Hintergrundsdruck, das vom Target 2 abdampfende Material innerhalb von wenigen Zentimetern gestreut wird. Dies führte, wenn in der Vakuumkammer insgesamt ein solcher Druck herrschen würde, zu einer drastischen Erniedrigung der Aufdampfrate und zum Verlust der Richtcharakteristik des Dampfstrahls. Beides würde die Herstellung von gut biaxial texturierten Schichten verhindern. Überdies ist der Betrieb der Quelle in diesem Druckbereich bei der Verwendung von reaktiven Gasen im allgemeinen und Sauerstoff im speziellen nicht mehr möglich. Deshalb ist im allgemeinen eine Drucküberhöhung am Substrat 4 vorzuziehen.

Zur Drucküberhöhung wird im speziellen das Substrat 4 mit einem Käfig 6 umgeben in den das entsprechende Gas gemäß dem Pfeil 7a durch einen entsprechende Leitung 7 eingelassen wird. Das Substrat 4 wird durch eine Öffnung 6a im Boden des Käfigs 6 bedampft. Zusätzlich kann durch partielles Pumpen, das durch eines oder mehrere Trennbleche 8 und entsprechende Anordnung der Vakuumpumpen (nicht gezeigt) erreicht wird, ein Druckgradient zwischen Target 2 und Substrat 4 eingestellt werden, so daß der Partialdruck des reaktiven Gases an der Quelle und zwischen Target 2 und Substrat 4 weiter erniedrigt wird.

Die in der Zeichnung dargestellte Anordnung stellt nur eine Möglichkeit der Drucküberhöhung dar. Prinzipiell können auch alle anderen in der Technik üblichen Verfahren oder Vorrichtungen verwendet werden, die mit diesem Verfahren kompatibel sind.

Weitere Möglichkeiten zur Anordnung von Aufdampfmaterialquellen. Substrat und Drucküberhöhungsbereichen sind in den älteren Anmeldungen DE 196 31 101.1 sowie DE 196 80 845.6 (entspricht der PCT/DE 96/02096) angegeben, Die hieraus entnehmbaren Beispiele betreffen jeweils Varianten, bei denen eine Drucküberhöhung zusammen mit einer zeitlichen Trennung der Oxidation und der Beschichtung realisiert wurde. Hierzu wird eine stationäre (DE 196 80 845.6) oder bewegliche (DE 196 31 101.1) Sauerstofftasche zumindest weitgehend abgedichtet an einem insbesondere beweglichen Substrat gehalten, so daß Bereiche, in denen ein Aufdampfen erfolgte anschließend von der Sauerstofftasche abgedeckt werden. Dies ermöglicht die Drucküberhöhung und Gaszufuhr auch ohne Beeinflussung des Aufdampfens selbst.

Ohne Einschränkungen kann das schräge Aufdampfen auch statt mit einem schräg zu den Aufdampfmaterialquellen angeordneten Substrat auch so realisiert werden, daß die Aufdampfmaterialquellen jeweils in geeigneter Weise seitlich versetzt vom Schichtbildungsbereich auf dem Substrat angeordnet sind, so daß nicht das vertikal aufsteigende Material, sondern seitlich von den Aufdampfmaterialquellen wegdampfendes Material unter dem gewünschten Winkel auf das Substrat trifft. Bei einem in einer horizontalen Ebene bewegten Substrat kann so durch unmittelbar aneinander anschließende Schichtbildungsbereiche für die Pufferschicht und jede Deckschicht zu deren Bildung jeweils ein anderer Winkel eingestellt sein. Anders ausgedrückt nutzt man, wenn z.B. die Pufferschicht und die Deckschichten aus denselben Materialien gebildet werden, daß zunächst unter einem Winkel α₁ auftreffender Dampf auf einen seitlich der Aufdampfmaterialquelle für das Pufferschichtmaterial liegenden Schichtbildungsbereich trifft und dann gleich anschließend unter einem Winkel α₂ < α₁ auftreffender Materialdampf auf einen weniger seitlich der Aufdampfmaterialquelle für das Deckschichtmaterial (identisch dem Pufferschichtmaterial) liegenden Schichtbildungsbereich trifft. Ggf. kann ein Zwischenbereich zwischen zwei Schichtbildungsbereichen durch Blenden abgedeckt sein.

Die Methode des thermischen Verdampfens und speziell des thermischen Verdampfens durch Elektronenstrahlen hat mehrere Vorteile gegenüber anderen Verfahren zur Schichtherstellung, wie z.B. der aus dem Stand der Technik bekannten Laserablation (siehe EP 669 411 A2). Durch die zur Verfügung stehende hohe thermische Heizleistung beim thermischen Verdampfen können sehr hohe Aufdampfraten im kontinuierlichen Betrieb erreicht werden. Diese sind notwendig für die Ausrichtung der Schichten, wie unten näher erklärt ist. Des weiteren ist der Abstand vom Target zum Substrat prinzipiell nicht beschränkt, so daß große Flächen simultan beschichtet werden können. Das Nachfüllen des Targetmaterials ist problemlos möglich, da dieses einfach z.B. in einen Verdampfungstiegel gefüllt wird: Dies ist mit Hilfe von automatischen Nachfülleinrichtungen auch im Vakuum möglich. Damit ist eine kontinuierliche Beschichtung großer Flächen möglich, ohne das Vakuum unterbrechen zu müssen. Die oben genannten Vorteile des thermischen Verdampfens tragen zur Wirtschaftlichkeit des Verfahrens bei und sind bei anderen Depositionsverfahren nicht gegeben.

Deponiert man mit der oben beschriebenen Anordnung auf ein gekipptes Substrat unter bestimmten Depositionsbedingungen wie Depositionsrate, Kippwinkel α₁, Substrattemperatur, Partialdruck und Gasart, so erhält man eine Schicht des Depositionsmaterials (Pufferschicht), die in einer gewissen Weise texturiert ist. Bei anders gewählten Depositionsbedingungen erhält man anders texturierte Schichten.

Im Rahmen der vorliegenden Erfindung wurde entdeckt, daß man, um z.B. eine biaxiale Textur in Metalloxidschichten zu erzeugen, die oben genannten Depositionsbedingungen, im speziellen Depositionsrate. Substrattemperatur, Partialdruck und Gasart, derart wählen kann, daß eine Facettierung der aufwachsenden Mikrokristallite auftritt. Unter Facettierung wird verstanden, daß die Oberfläche der Kristallite der aufgebrachten Schicht im wesentlichen aus in etwa ebenen Flächen besteht, die meist niedrig indizierte Kristallflächen darstellen (z.B. {100}, {110}, {111}), die auch leicht verkippt sein können (Vizinalflächen). Die Facettierung wird im speziellen dadurch erreicht, daß ein genügend hoher Druck eines geeigneten Gases oder Gasgemisches am Substrat herrscht und daß eine ausreichend hohe Depositionsrate benutzt wird. Ist dies der Fall, so wird eine biaxiale Textur bereits bei sehr kleinen Winkeln α₁ ab typischerweise 10° erreicht.

Der Mechanismus der Texturbildung läßt sich folgendermaßen verstehen. Deponiert man unter diesen Depositionsbedingungen auf ein um den Kippwinkel α₁ gekipptes Substrat, so werden diejenigen Kristallite mit der höchsten lokalen Rate bedampft, deren oberste Facette eine Oberflächennormale aufweist, die ungefähr in Depositionsrichtung zeigt. Diese Kristallite wachsen demzufolge am stärksten. Durch die gegenseitige Abschattung bei schräger Deposition und einer gerichteten Deposition wird bereits eine Kristallachse ausgerichtet oder ausgezeichnet. Unter einer gerichteten Deposition versteht man im vorliegenden Fall, daß die auftreffenden Alome/Moleküle einen Impuls mit einer Lateralkomponente haben, die zu einer Vorzugsrichtung der Diffusion führt. Zusätzlich führt eine anisotrope Wachstumsgeschwindigkeit zu der Ausrichtung der zweiten Achse. Damit erhält man biaxial texturierte dünne Schichten. Die Qualität der biaxialen Textur nimmt aufgrund der Wachstumsselektion durch Abschattung mit zunehmender Schichtdicke zu.

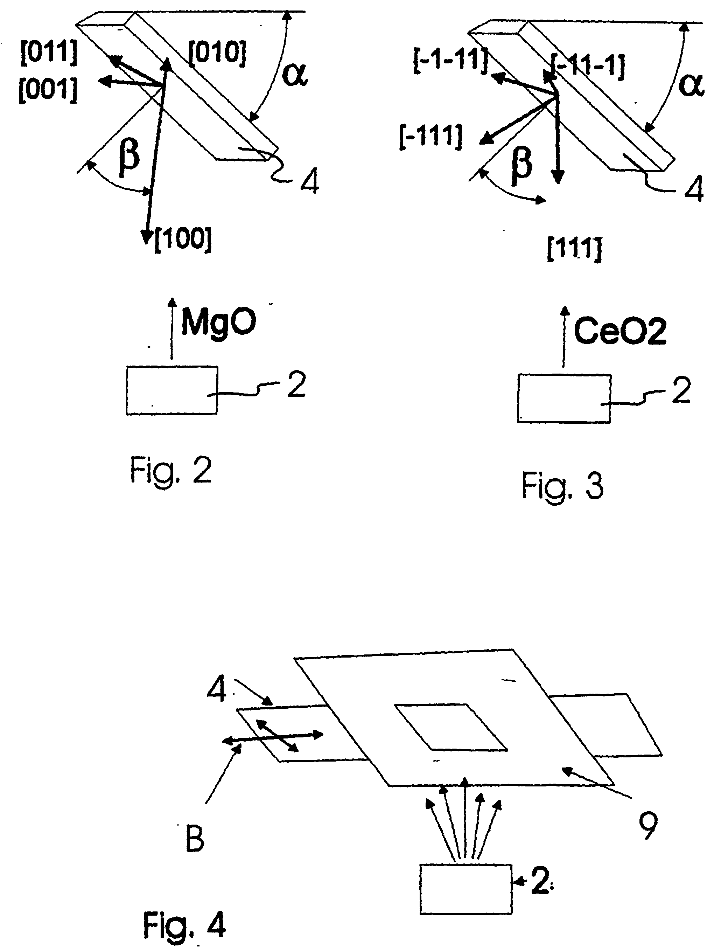

Die Textur läßt sich im allgemeinen folgendermaßen beschreiben. Eine Kristallachse [hkl] (z.B. [100]) stellt sich mehr oder weniger in Depositionsrichtung ein. Weitere entsprechend der Kristallsymmetrie äquivalente Kristallachsen (z.B. [010], [001]) stellen sich in etwa parallel zur Oberfläche (Fig. 2) ein. Welche äquivalenten Kristallachsen auf diese Weise ausgezeichnet sind, ist von dem Depositionsmaterial und den Depositionsparametern abhängig. Das hat zur Folge, daß sich z.B. bei MgO als Pufferschichtmaterial die [0-11] Richtung (oder analog die [01-1] Richtung) parallel zur Substratoberfläche und senkrecht zur Kristallachse [hkl], z.B. [100], und damit mehr oder weniger in Depositionsrichtung einstellt.

Im Gegensatz dazu beobachtet man bei der Deposition auf nicht (α₁ = 0°) oder nur wenig verkippte Substrate eine andere Orientierung der (Puffer-) Schicht (Wachstumsregime II). Je nach den gewählten Depositionsbedingungen richtet sich eine bestimmte Kristallachse <hkl> in Normalenrichtung aus. Diese Kristallachse ist nicht notwendigerweise die, welche in Wachstumsregime I in der oben beschriebenen Art und Weise ausgezeichnet ist. Der Wechsel von Wachstumsregime I zu Wachstumsregime II erfolgt bei sonst unveränderten Depositionsbedingungen ab einem bestimmten Kippwinkel bzw. ab einer bestimmten Depositionsrate, wobei auch ein Übergangsbereich mit Anteilen des Wachstumsregimes I und des Wachstumsregimes II auftreten kann. Depositionsparameter, wie Druck und Substrattemperatur, beeinflussen den Übergang. Damit unterscheidet sich dieses Verfahren wesentlich von der oben erwähnten Methode der Laserablation auf ein verkipptes Substrat (ISD), da sich bei dieser immer, d.h. auch bei senkrechter Deposition, eine bestimmte Kristallachse in etwa in Depositionsrichtung stellt (vgl. EP 669 411 A2).

Der oben beschriebene Mechanismus ist von grundlegender Natur, so daß z.B. biaxial orientierte Schichten grundsätzlich mit vielen Materialien erzeugt werden können. Dabei wird durch die Wahl entsprechender Depositionsparameter eine Facettierung der aufwachsenden Mikrokristallite erreicht. Weiter unten werden konkrete Daten für Beispiele mit MgO und CeO₂ angegeben.

Durch geeignete Wahl der Depositionsparameter läßt sich, wie oben beschrieben wurde, z.B. mit MgO eine biaxial texturierte Pufferschicht erzeugen, die beispielsweise eine für YBCO geeignete Kristallorientierung aufweist. Diese ist dadurch ausgezeichnet, daß die [100] Kristallachse des Puffers möglichst wenig aus der Substratnomalen gekippt ist und die biaxiale Textur möglichst gut ist.

Bei der direkten Deposition eines Supraleiters auf oben beschriebene MgO-Pufferschichten wächst dieser aufgrund einer ungenügenden Kristallinität der Oberfläche und aufgrund der großen Porösität der Pufferschicht nicht epitaktisch auf.

Deshalb werden vor der Deposition des Supraleiters zusätzlich eine oder mehrere weitere Deckschichten epitaktisch auf die bereits vorhandene biaxial texturierte Pufferschicht aufgebracht. Diese weiteren Schichten bestehen im allgemeinen aus einem beliebigen für die Deposition des Supraleiters geeigneten Material. Im speziellen Beispiel wurde MgO verwendet. Durch geeignete Wahl des Materials und der Depositionsbedingungen, wie u.a. Rate, Substrattemperatur, Kippwinkel α₂ wird eine für das Wachstum der Supraleiterschicht geeignetere Oberfläche erzeugt. Im speziellen können durch senkrechte Deposition α₂ = 0 oder Deposition unter kleinen Kippwinkeln α₂ des Pufferschichtmaterials als Deckschicht die Poren in der Pufferschicht geschlossen werden, so daß diese eine bessere Diffusionsbarriere zwischen z.B. Supraleiter und Substratmaterial darstellt und eine geschlossene Oberflächenschicht resultiert. Diese zusätzliche Deckschicht oder Deckschichten kann/können in derselben oder einer anderen Beschichtungsanlage hergestellt werden. Von Vorteil ist die Beschichtung ohne das Substrat zwischenzeitlich der Umgebungsluft auszusetzen, da dies zur Degradation der Puffer- und Deckschichten führen kann.

Die oben beschriebenen Verfahren zur Herstellung einer biaxial texturierten Pufferschicht und zur Herstellung von Deckschichten auf dieser Pufferschicht können, wie in der Fig. 4 gezeigt ist, so ausgeführt werden, daß das Substrat 4 gegenüber dem Target 2, in einer oder zwei Richtungen gemäß den Pfeilen B bewegt wird, was eine kontinuierliche Beschichtung eines großflächigen oder bandförmigen Substrates ermöglicht. Dabei wird die zu beschichtende Fläche durch eine entsprechende Blende 9 auf den gewünschten Bereich eingeschränkt, damit der Winkel α (entsprechend der jeweils gerade aufzubringenden Puffer- oder Deckschicht α₁ bzw. α₂) hinreichend genau definiert werden kann.

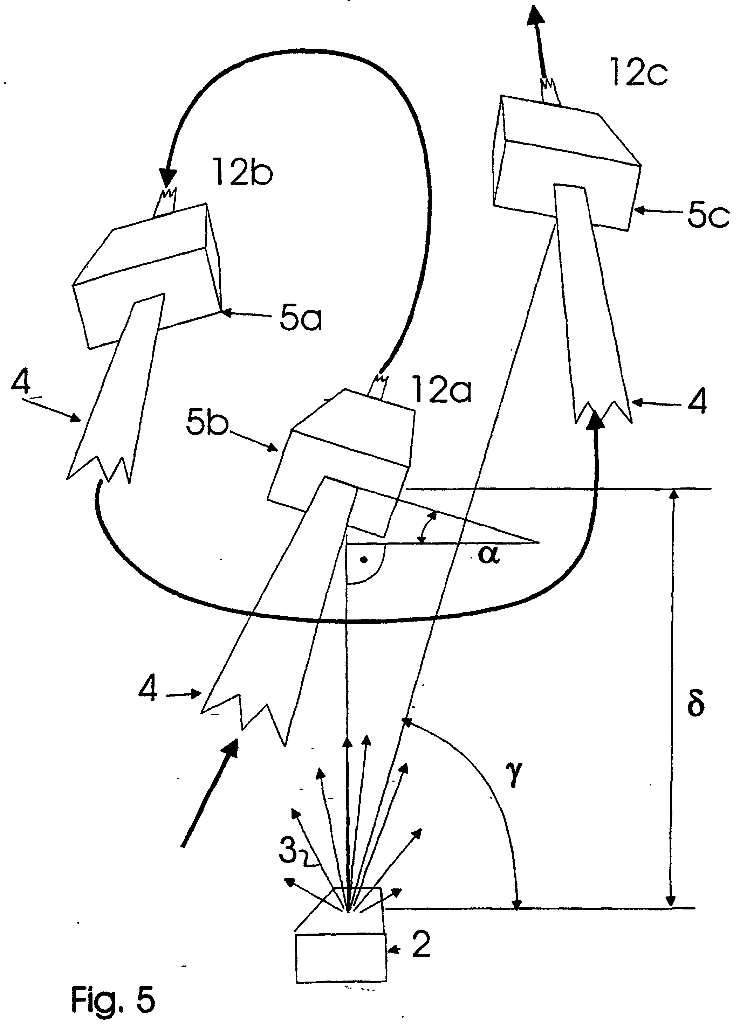

Es ist im allgemeinen auch möglich, parallel mehrere Substrate oder Substratteile zu beschichten. Ohne Beschränkung der vielen möglichen Anordnungen ist ein Ausführungsbeispiel in Fig. 5 gezeigt. Dazu werden im allgemeinen an verschiedenen Orten der Vakuumkammer Schichten durch Verdampfen von einer einzigen Quelle 2 hergestellt. Im speziellen kann ein bandförmiges Substrat 4 nacheinander zu verschiedenen Beschichtungsorten 12a (Pufferschichtaufbringung), 12b bis 12c (Aufbringung von Deckschichten) transportiert werden. Dabei kann unter Ausnutzung der gesamten Dampfausbreitungskeule (dargestellt durch die Pfeile 3) durch Variation des Abstandesδ oder Richtung zur Targetoberfläche γ die gewünschte Rate und durch Variation der lokalen Heizleistungen der Heizer 5a bis 5c die gewünschten Temperaturen gewählt werden. An den verschiedenen Beschichtungsorten kann das Substrat 4 mit unterschiedlichen Depositionswinkeln (beispielsweise ist nur an der Aufdampfstelle 12a der Winkel α₁ gezeigt, wobei aus der Darstellung in der Fig. 5 ersichtlich ist, daß das Substrat 4 an den anderen Aufdampfstellen 12b und 12c unter anderen Winkeln α zum Target 2 steht) beschichtet werden. Somit ist im speziellen bei einem Bandmaterial die Herstellung von mehreren Schichten als Pufferschicht und Deckschichten des selben Materials auf einem Band während eines Beschichtungsprozesses möglich.

Zum anschließenden Aufbringen von dünnen Schichten eines Hochtemperatursupraleiters im allgemeinen und YBCO im speziellen, können prinzipiell alle gängigen Verfahren der Dünnschichtherstellung, die mit dem Substratmaterial kompatibel sind, verwendet werden. Als Verfahren seien genannt das thermische Koverdampfen, die Laserablation, Hochund Niederdruckzerstäuben oder MOCVD.

Das thermische Koverdampfen ist zur großflächigen Deposition bei hohen Raten geeignet und wird im folgenden kurz beschrieben. Man bringt das Substrat mit der Pufferschicht und ggf. den Deckschichten in eine geeignete Vakuumkammer (nicht gezeigt). Von Vorteil ist auch hier die Beschichtung ohne das Substrat zwischenzeitlich der Umgebungsluft auszusetzen, da diese zur Degradation der Pufferschicht bzw. ggf. Deckschicht führen kann. Im Fall des thermischen Koverdampfens von YBCO werden anschließend die Metallé Y, Ba und Cu aus resistiv geheizten sogenannten Schiffchen unter Regelung der Aufdampfrate verdampft. Das Substrat befindet sich über den Verdampferquellen und wird auf Temperaturen von ca. 680°C geheizt. Bei genügend hohem Sauerstoffdruck am Substrat und der korrekten Stöchiometrie der Metalle wächst dann YBCO auf der Pufferschicht auf.

Die Puffer- und ggf. Deckschichtherstellung und HTSL-Beschichtung auf Substraten und insbesondere Bändern kann auch in demselben Durchlauf in derselben Beschichtungskammer erfolgen, indem getrennte Verdampferquellen für Pufferschicht, ggf. Deckschichten und HTSL verwendet werden. Die Schichtdicken können dabei durch Wahl der Verdampfungsrate, durch Blenden oder durch den Abstand Quelle-Substrat aufeinander, bzw. auf die Durchlaufgeschwindigkeit des Substrates abgestimmt werden.

Die Bezeichnung der Kristallrichtungen und Ebenen erfolgt mit Hilfe der Millerschen Indizes h, k und 1. Dabei bezeichnet [hkl] eine bestimmte Kristallachse, <hkl> alle aufgrund der Kristallsymmetrie äquivalenten Kristallachsen, (hkl) eine bestimmte Kristallebene, und {hkl} alle aufgrund der Kristallsymmetrie äquivalenten Kristallebenen.

### Beispiele

### 1. MgO Einfachschichten:

Es wurden Schichten aus MgO auf SiO₂/Si (thermisch oxidiertes Silizium) - Substrat durch Elektronenstrahlverdampfen hergestellt. Die Wachstumsrate betrug zwischen 20 und 40 Å/s. Der Partialdruck von O₂ am Substrat betrug ca. 1x10⁻³ mbar. Die Substrattemperatur wurde zwischen Raumtemperatur und 710°C variiert.

Bei einem genügend großem Kippwinkel α₁ beobachtet man die in Fig. 2 gezeigte Orientierung der aufgedampften Schicht (Wachstumsbereich I). Die [100] Achse liegt in der Ebene, die von der Substratnormale und der Depositionsrichtung aufgespannt wird und schließt den Neigungswinkel β mit der Substratnormalen ein. Die [010] und [001] Achsen sind ausgerichtet und zeigen so nach oben, daß die [011] Richtung ebenfalls in der oben genannten Ebene liegt. Diese Ebene stellt die (0-11) Kristallebene dar, oder anders ausgedrückt, die [0-11] Kristallachse liegt somit parallel zur Substratoberfläche und senkrecht zur [100] Achse. Die Qualität der biaxialen Textur wurde mit Hilfe von Röntgen-Polfigurmessungen des MgO-(200)-Reflexes bestimmt. Als Maß für die einkristalline Güte der Schichten ist die Halbwertsbreite Ω der [010] bzw. [001] Reflexe senkrecht zur [100] Richtung angegeben.

Durch Variation der Depositionsparameter Beschichtungsrate, Substrattemperatur, Sauerstoffpartialdruck am Substrat und Aufdampfrichtung oder Kippwinkel α₁ des Substrats lassen sich der Neigungswinkel β und die Halbwertsbreite Ω in einem weiten Bereich variieren. Im folgenden werden ausgewählte Abhängigkeiten gezeigt.

**Tabelle 1:**

| Winkel β und Halbwertsbreite Ω von MgO Schichten, die bei einem Kippwinkel α₁ von 55° und verschiedenen Substrattemperaturen hergestellt wurden. | | |
|---|---|---|
| Temperatur | β | Ω |
| 25 °C | 38° | 8° |
| 300 °C | 30° | 12° |
| 530 °C | 24° | 25° |

**Tabelle 2:**

| Neigungswinkel β und Halbwertsbreite Ω von MgO Schichten, die bei einer Substrattemperatur von 300°C bei verschiedenen Kippwinkeln α hergestellt wurden. | | |
|---|---|---|
| α | β | Ω |
| 20° | 19° | > 40° |
| 30° | 17,5° | 40° |
| 40° | 20,5° | 20° |
| 55° | 30° | 12° |

Bei einem festen Kippwinkel von α₁ = 55° sind der Neigungswinkel β und die Halbwertsbreite Ω von der Substrattemperatur derart abhängig, daß bei steigender Substrattemperatur der Neigungswinkel β abnimmt und die Halbwertsbreite Ω zunimmt, wie in der Tabelle 1 gezeigt ist.

Ebenso wurde bei wachsendem Kippwinkel α₁ eine Zunahme des Winkels β und eine Abnahme der Halbwertsbreite Ω gemessen, wie in der Tabelle 2 gezeigt.

Die Halbwertsbreite Ω verkleinert sich mit zunehmender Schichtdicke wie in der Tabelle 3 gezeigt. Der Neigungswinkel β zeigt dagegen keine Abhängigkeit von der Schichtdikke.

**Tabelle 3:**

| Neigungswinkel β und Halbwertsbreite Ω von MgO Schichten in Abhängigkeit von der Schichtdicke. Die Schichten wurden bei einer Substrattemperatur von 300°C und einem Kippwinkeln α₁ = 35° hergestellt. | | |
|---|---|---|
| Temperatur | β | Ω |
| 80 | 25° | 60° |
| 160 | 27° | 45° |
| 325 | 26° | 24° |
| 625 | 22° | 12° |
| 1.265 | 23° | 8° |

Bei der Deposition auf ein ungefähr senkrechtes Substrat (α₁ = 0°) richtet sich bei Substrattemperaturen von Raumtemperatur bis 530° C die <111> Achse senkrecht zur Oberfläche aus. Das entspricht dem Wachstumsbereich II. Das heißt, daß bei senkrechter Deposition die <111> - Achse ausgezeichnet ist. Bei einer Substrattemperatur ca. 700°C wurde polykristallines Wachstum ohne Vorzugsorientierung beobachtet.

### 2. YBCO auf MgO Puffer-/Deckschichtpaketen:

Die oben beschriebenen biaxial texturierten MgO Schichten eigen sich beispielsweise als Pufferschichten auf polykristallinen oder amorphen Substraten zur Deposition von HTSL-Dünnschichten im allgemeinen und YBCO im speziellen. Als Substratmaterial wurde poliertes, polykristallines, partiell Y₂O₃ stabilisiertes ZrO₂ (PSZ) verwendet. Auf dieses polykristalline Substrat wurden aufeinander eine Pufferschicht und dann zwei Deckschichten (MgO1 bis MgO3) und die YBCO-Schicht aufgebracht.

Die erste Pufferschicht aus MgO (MgO1) wird mit dem oben beschriebenen Verfahren des schrägen Aufdampfens hergestellt. Für Supraleiterschichten mit hohen kritischen Stromdichten j_{c} muß diese Pufferschicht eine kleine Halbwertsbreite Ω und einen kleinen Neigungswinkel β aufweisen. Dieses erreicht man mit dicken Schichten, die bei kleinem Kippwinkel α₁ aufgedampft werden. Es wurden deshalb Kippwinkel von α₁ = 15° und α₁ = 25° verwendet. Die Substrattemperatur betrug 25°C, der Sauerstoffdruck am Substrat war etwa 1 x 10⁻³ mbar und die Aufdampfrate in Substratnormalenrichtung 4 nm/s. Es wurde eine Schichtdicke von ca. 2 µm aufgebracht.

Anschließend wird das Substrat waagerecht (α₂ = 0°) in einen Heizer eingebaut und auf 700°C im Vakuum aufgeheizt. Es erfolgte die Deposition von zwei Deckschichten aus MgO, im weiteren MgO2 und MgO3 genannt, auf die bereits vorhandene Pufferschicht (MgO1). Für die Schicht MgO2 werden 500 nm mit 0,5 nm/s deponiert. Anschließend wurden 100 nm mit 0,1 nm/s für die Schicht MgO3 aufgedampft. Die Schichten MgO2 und MgO3 wachsen epitaktisch auf MgO1. Sie schließen die Spalten in dieser Schicht, die durch die schräge Deposition entstanden, und erzeugen eine für das epitaktische Wachstum von YBCO geeignete Oberfläche. Zur Bestimmung der Textur der Puffer- und Deckschichten wurden Polfiguren des (200)-Reflexes von des MgO-Schichtpaketes (MgO1, MgO2 und MgO3) angefertigt. Die damit bestimmten Werte für die Halbwertsbreite Ω und den Neigungswinkel β sind in Tab. 4 gezeigt.

**Tabelle 4:**

| Ergebnisse der Deposition von YBCO auf MgO-Puffer- und Deckschichtpaketen | | | | |
|---|---|---|---|---|
| Probe Nr. | Kippwinkel α₁ | Neigungswinkel β der MgO- Schichten | Halbwertsbreite Ω der MgO-Schichten | J_{c} (77K) in A/cm² |
| 1 | 15° | 19° | 10° | 2.8x10⁵ |
| 2 | 25° | 25° | 7° | 1.4x10⁵ |

Zuletzt wurde die Supraleiterschicht mit dem Verfahren des thermischen Koverdamptens aufgebracht. Die Substrattemperatur betrug 680 °C und der Sauerstoffpartialdruck am Substrat betrug ca. 7 x 10⁻³ mbar. Die Schichtdicke betrug 550 nm. Die Orientierung der Supraleiterschicht ist folgendermaßen. Die [001] Achse des Supraleiters richtet sich in etwa parallel zu der [100] Achse des MgO-Puffers. Die [100] und [010] Achsen (a- bzw. b- Achse) des YBCO sind parallel zu den in etwa in der Substratebene liegenden [010]- und [001]-Achsen des MgO.

Die so hergestellten Supraleiterschichten wiesen kritische Stromdichten über 0.1 MA/cm² bei 77 K auf, bei einem maximalen j_{c} von 0.28 MA/cm² (siehe Tabelle 4). Dieser Wert liegt mehr als eine Größenordnung über der kritischen Stromdichte von YBCO-Filmen auf untexturiertem Substrat. Es wurde also eine deutliche Erhöhung der kritischen Stromdichte erreicht.

### 3. CeO₂:

Es wurden Schichten aus CeO₂ auf Substraten aus SiO₂/Si und der Nickelbasislegierung Hastelloy C® durch Elektronenstrahlverdampfen hergestellt. Die Wachstumsrate betrug 40 Å/s. Der Partialdruck von O₂ am Substrat betrug 4 x 10⁻⁴ mbar.

**Tabelle 5:**

| Neigungswinkel β und Halbwertsbreite Ω von CeO₂ Schichten, die bei verschiedenen Substrattemperaturen hergestellt wurden. | | |
|---|---|---|
| Temperatur | β | Ω |
| 125 °C | 60° | 16° |
| 230 °C | 60° | 19° |
| 440 °C | 55° | 29° |
| 560 °C | 48° | 50° |

Bei der Deposition auf ein um den Winkel α₁ = 55° verkipptes Substrat sind die Puffer- und Deckschichten, wie in Fig. 3 gezeigt ist, orientiert (Wachstumsbereich I). Die [111] Achse liegt in der Ebene, die von der Substratnormale und der Depositionsrichtung aufgespannt wird und schließt den Neigungswinkel β mit der Substratnormalen ein. Die [-111] Achse liegt ebenfalls in dieser Ebene, zeigt aber in etwa in Substratnormalenrichtung. Die [-1-11] und [-11-1] Achsen sind ausgerichtet und zeigen dementsprechend nach oben. Die [0-11] Kristallachse liegt dabei parallel zur Substratoberfläche und senkrecht zur [111] Achse. Die Qualität der biaxialen Textur wurde mit Hilfe von CeO₂-(111) Polfigurmessungen bestimmt.

Als Maß für die einkristalline Güte der Schichten ist die Halbwertsbreite Ω der [-1-11] und [-11-1] Reflexe in der Substratebene in der Tabelle 5 angegeben. Die Halbwertsbreite Ω nimmt mit zunehmender Depositionstemperatur zu, gleichzeitig nimmt der Kippwinkel β ab.

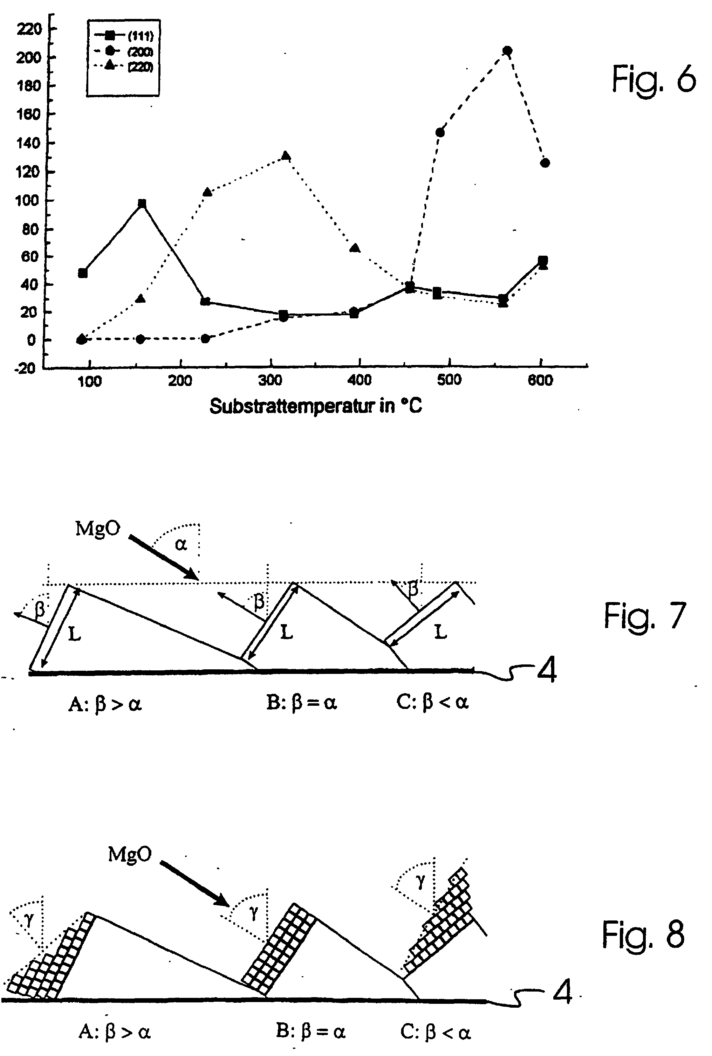

- Im Gegensatz dazu richten sich bei der Deposition auf ein senkrechtes (α₁ = 0) oder nur leicht verkipptes Substrat je nach Substrattemperatur unterschiedliche Kristallachsen senkrecht zur Oberfläche aus, wie in der Fig. 6 gezeigt ist. Das entspricht dem Wachstumsbereich II. In der Fig. 6 ist die Intensität der (111), (200), (220) Röntgenbeugungsreflexe von CeO₂-Schichten, die senkrecht bei verschiedenen Substrattemperaturen aufgedampft wurden graphisch dargestellt.

Nachfolgend wird der Effekt der Verkippung der Texturachse gegen die Substratnormale anhand von Schemadarstellungen in den Fig. 7 bis 10 näher erläutert. Dabei soll zunächst qualitativ untersucht werden, um welchen Winkel β die <100>-Achse bevorzugt verkippt ist, wenn die Deposition unter einem bestimmten Winkel α erfolgt. D.h., es wird ermittelt, wie die Orientierung der <100>-Achse sein muß, daß mit andauernder Deposition anders orientierte Kristallite abgeschattet werden. Zur Vereinfachung wird beispielsweise von quaderförmigen Kristalliten ausgegangen (Fig. 7), bei denen neben der <111>-eine <100>-Achse in der Depositionsebene liegt und um verschiedene Winkel β gegen die Substratnormale verkippt ist, nämlich β > α (A), β = α (B) und β < α (C). Die Kristallite sollen dieselben Wachstumschancen haben, was durch eine gleiche Oberfläche (insbesondere Querschnittslänge L), ein einheitliches Niveau ihrer Spitze und einem gegenseitigen Abstand gegeben ist, der so groß ist, daß zu Beginn keinerlei Abschattung vorliegt. In der Fig. 7 ist die betrachtete Ausgangslage bei der Deposition auf unterschiedlich verkippte Kristallite im Schema dargestellt.

Vernachlässigt man nun die isotrope thermisch induzierte Diffusion, so wandern die auf der Oberfläche abgeschiedenen Moleküle in die Richtung ihrer lateralen Geschwindigkeitskomponente vₗₗ (die Geschwindigkeit stammt von der Gasphase, vgl. gerichtete Diffusion weiter oben). Entsprechend verläuft das Wachstum im Fall B parallel zur Oberfläche, während sich im Fall A die Moleküle bevorzugt am unteren Bereich des Kristallits sammeln und im Fall C an der Spitze (Fig. 8). Wie oben bereits angenommen, können die Moleküle sogar etwas über den Rand der Unterlage hinaus driften. Dies erklärt auch das beobachtete senkrechte Wachstum der Säulen. In der Fig. 8 ist die Situation von Fig. 7 nach einer gewissen Depositionsdauer gezeigt.

Insgesamt wird klar, daß der Fall C die bevorzugte Orientierung ist. da sie am schnellsten nach oben wächst und alle anderen Wachstumsformen durch zunehmende Abschattung unterdrückt. Es folgt also β < α. Außerdem erkennt man, daß die Normale der resultierenden makroskopischen Oberfläche der Kristallite allmählich in die Depositionsrichtung kippt. Tatsächlich stellt man bei der Auswertung von REM-Aufnahmen sowie der Streifen auf RHEED-Bildern fest. daß der Winkel γ zwischen den Normalen von Substrat und Oberfläche der Säulenspitze mit zunehmender Schichtdicke wächst.

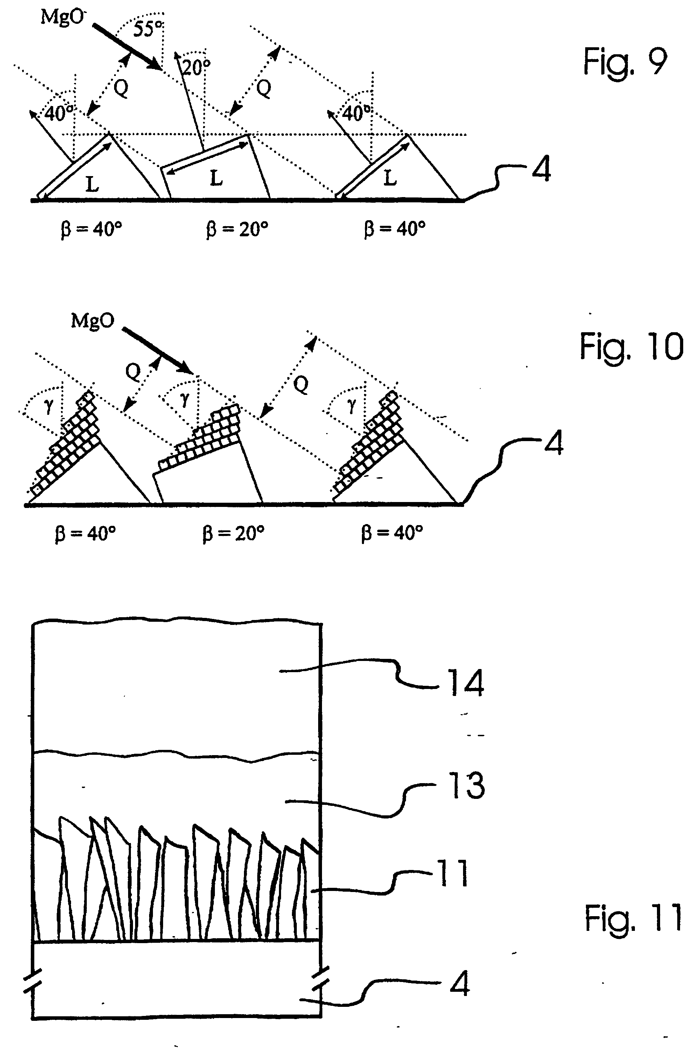

Der Effekt, daß sich die Moleküle an der Kristallitkante sammeln. ist dann am größten, wenn v_{II} maximal ist, was β = 0° entspricht. Um zu verstehen, daß das bevorzugte β dennoch keineswegs verschwindet, muß man berücksichtigen, daß der auf der Kristallitfläche ankommende Teilchenfluß mit dem "effektiven Querschnitt" Q der Fläche wächst, also bei konstantem L proportional zu cos (α - β) ist. Der resultierende Sachverhalt ist in den Fig. 9 und 10 dargestellt. Unter den gleichen Voraussetzungen wie in der Fig. 7 werden zwei Kristallite mit entsprechend β = 40° und β = 20° und deren gegenseitige Abschattung betrachtet, wenn die Deposition unter einem Winkel von 55° erfolgt.

In der Fig. 9 ist dargestellt, daß zur betrachteten Startzeit die Kristallitspitzen auf demselben Niveau liegen und die Querschnitte L identisch sind. Der effektive Querschnitt Q ist jedoch proportional zu cos (α - β).

Da mehr Moleküle pro Zeiteinheit auf den stärker verkippten Kristallit abgeschieden werden, nimmt für diesen Q mit der Zeit zu, während der effektive Querschnitt für den flacher orientierten Kristallit durch die Abschattung kleiner wird (Fig. 10). In der Fig. 10 ist schematisch dargestellt, wie nach einer gewissen Abscheidedauer die Kristallite mit β = 40° den schwächer verkippten Kristallit effektiver abschatten als umgekehrt.

Die stärker verkippte Orientierung wird sich also durchsetzen. Aus demselben Grund wird der Oberflächenwinkel γ nicht größer als α, sondern es stellt sich - wie beobachtet - bei längerer Deposition schließlich der stationäre Fall ein, daß der maximale Querschnitt erreicht wird, indem die Oberfläche der Säulenspitze senkrecht zum Strahl steht. Entsprechend ist die resultierende Oberfläche keine {100}-Fläche, sondern nur vizinal zu ihr. Für die Einstellung der In-plane oder der biaxialen Textur ist entscheidend, daß die <111>-Richtung im Fall von z.B. MgO die bevorzugte oder schnellste Wachstumsrichtung darstellt. Damit wachsen Kristallite. deren <111>-Richtung möglichst normal zur Oberfläche steht, am schnellsten. Das bedeutet andererseits. daß im Idealfall die Einfallsebene eine (01-1)-Fläche darstellt. Dies führt zu der beobachteten biaxialen Textur.

Insgesamt wird sich also bei schräger Deposition eine Textur herauskristallisieren. bei der 1.) die (01-1)-Fläche parallel zur Einfallsebene ist, 2.) die <100>-Achse mit der Substratnormalen einen Winkel β einschließt, der ausreichend klein ist, so daß die Moleküle eine gewisse Strecke in Richtung ihres Impulses driften, und 3.) unter Beachtung von 2.) die Achse <100> möglichst wenig gegenüber der Depositionsrichtung verkippt ist.

In der Fig. 11 ist schematisch ein Querschnitt durch einen Teil eines Schichtmaterials mit dem erfindungsgemäßen Aufbau dargestellt. D.h., daß der Reihe nach übereinander liegen: ein Substrat 4, eine Pufferschicht 11, eine Deckschicht 13 und eine orientierte oxidische Dünnschicht 14. Wie dem Schema deutlich zu entnehmen ist, weist die Pufferschicht 11 eine stark zerklüftete, ungleichmäßige und mit tiefen Lücken versehene Oberfläche auf, die ein direktes epitaktisches Aufwachsen der orientierten oxidischen Dünnschicht 14 zumindest in guter insbesondere zumindest annähernd einkristalliner Qualität kaum zuläßt. Durch die erfindungsgemäße Deckschicht 13, die unter einem anderen Winkel auf das Substrat 4 aufgedampft wird, als die Pufferschicht 11, wird die Oberflächenstruktur der letzteren verbessert, wie z.B. ausgeglichen und eingeebnet, so daß hervorragende Voraussetzungen für ein epitaktisches Aufwachsen der orientierten oxidischen Dünnschicht 14 bestehen. Anstelle der einen Deckschicht 13 kann auch eine Mehrzahl von Deckschichten vorgesehen sein, die unter gleichen oder verschiedenen Winkeln aufgedampft werden und aus gleichen oder verschiedenen Materialien bestehen können. Aufdampfwinkel und Materialien von Pufferschicht 11 und Deckschicht 13 können ebenfalls verschieden oder gleich sein.

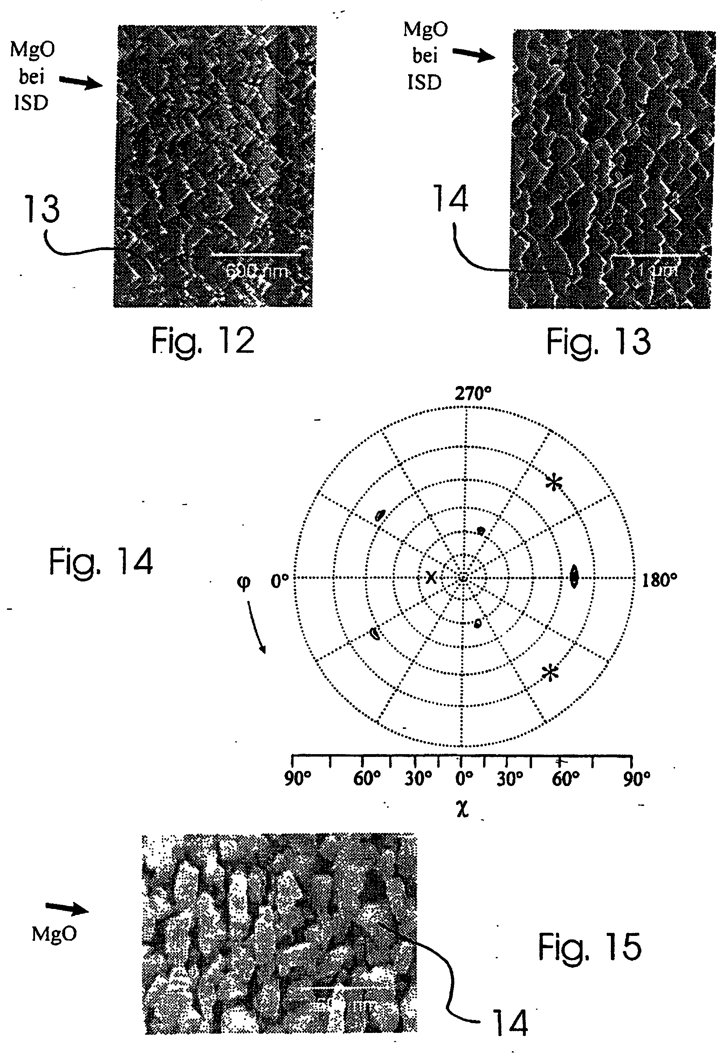

Nachfolgend wird noch ein Ausführungsbeispiel anhand einer Epitaxie von YBCO auf MgO unter Bezugnahme auf die Fig. 12 bis 15 erläutert. Dabei soll bei der Epitaxie von YBa₂Cu₃O_{7-δ} auf MgO die Notwendigkeit mehrerer MgO-Schichten als Puffer und Deckschichten erläutert werden.

Aus den oben beschriebenen Sachverhalten ist deutlich, daß es möglich ist, mittels ISD eine Texturierung von MgO zu erzielen, die bei Epitaxie von YBa₂Cu₃O_{7-δ} gute supraleitende Eigenschaften erwarten läßt. Es zeigt sich jedoch, daß die HTSL-Filme, die auf ISD-MgO abgeschieden werden, nicht die biaxiale Textur des Puffers übernehmen, sondern polykristallin wachsen (Fig. 15). Die Fig. 15 ist eine REM-Aufsicht auf einen YBCO-Film, der direkt auf eine ISD-Schicht MgO aufgedampft ist.

Entsprechend liegt das gemessene T_{c} nur bei 20K. Das nachfolgende Wachstum von YBCO scheint - zumindest beim angewendeten Prozeß - also nicht ausschließlich von der Textur des Puffers abzuhängen, sondern auch von seiner Morphologie.

Zwei Umstände scheinen sich ungünstig auf das epitaktische Wachstum von senkrecht abgeschiedenem YBa₂Cu₃O_{7-δ} auszuwirken: Die ungenügende Dichte der kolumnaren Schichten und die Tatsache, daß die Oberflächen der Säulenspitzen nicht exakt in die <100>-Richtung orientiert sind.

Aus diesem Grunde wird dazu übergegangen, vor der HTSL-Schicht weitere MgO-Deckschichten senkrecht auf der ISD-Schicht zu deponieren. Diese Deckschichten sollen die Textur der ISD-Schicht übernehmen und einerseits die Lücken zwischen den Wachstumssäulen auffüllen, andererseits aber auch die Säulenoberflächen "einebnen" und glätten.

Aus den durchgeführten Experimenten ergibt sich, daß die Homoepitaxie prinzipiell funktioniert und mit zunehmender Substrattemperatur besser wird. Deshalb ist es von besonderem Vorteil, einen Gleichgewicht-Stahlungsheizer zu benutzen, da sich mit ihm Temperaturen bis zu 750 °C erreichen lassen. Unter diesen Bedingungen werden tatsächlich die besten Ergebnisse bezüglich der Homoepitaxie erzielt, sofern die Depositionsrate ausreichend gering ist.

Beispielsweise wurden RHEED-Bilder (RHEED: Reflexion High Energy Electron Defraction) während der Abscheidung einer 500 nm dicken Deckschicht aufgenommen (Substrattemperatur: 734 °C, Abscheiderate; 30 nm/min). Der <100>-Kippwinkel β läßt sich aus dem Transmissionsbeugungsbild ermitteln, während der Oberflächenwinkel γ der Neigung der auftretenden Streifen entspricht. Bei diesem Ausführungsbeispiel können z.B. vor Beginn der Abscheidung die Oberflächen der ISD-Schicht um ca. 37° gegenüber der Substratnormalen verkippt sein. Dies ist im Rahmen der geringen Meßgenauigkeit konsistent mit der oben formulierten Annahme, daß sich die Flächennormale allmählich der Depositionsrichtung (α = 35°) zuneigt. Man stellt weiterhin fest, daß während der Deckschichtabscheidung der Winkel β konstant etwa 26° beträgt, was auf eine gute Epitaxie schließen läßt. Schließlich ist zu beobachten, daß gleichzeitig der Oberflächenwinkel γ abnimmt und einem Grenzwert zustrebt, der identisch mit β ist. Man erhält also einen Film, dessen mikroskopische Oberflächen exakte {100}-Flächen sind.

Dies wird besonders in REM-Aufnahmen deutlich. In der Fig. 12 ist die Oberfläche einer Probe eines Schichtmaterials dargestellt, das zunächst aus drei Schichten MgO besteht. Genauer ist die Fig. 12 eine Aufsicht auf die oberste Schicht MgO einer dreilagigen Probe. Die Lücken sind geschlossen, die Oberfläche besteht aus scharf begrenzten Kristalliten mit exakten {100)-Flächen.

Die erste Pufferschicht ist mittels ISD hergestellt. Die Depositionsparameter waren T = 25 °C, α = 25°, R = 240 nm/min, p = 9 x 10⁻⁴ mbar, D = 2 µm. Die beiden folgenden Deckschichten sind bei 700 °C und gleichem Sauerstoffdruck senkrecht aufgedampft, wobei zunächst eine 500 nm dicke Lage mit 30 nm/min aufgebracht wurde. und anschließend eine dünne Schicht (100 nm) mit 6 nm/min aufgebracht wurde, was durch die geringe Rate kristallographisch besonders definierte Oberflächen-zur Folge hat. Außerdem werden die ursprünglich vorhandenen Lücken der ISD-Schicht geschlossen.

Nachfolgend wird noch näher auf die Eigenschaften solcher der YBa₂Cu₃O_{7-δ}-Filme eingegangen.

YBCO-Schichten. die mittels reaktivem Koverdampfen auf Schichtsysteme der vorher beschriebenen Art abgeschieden werden, zeichnen sich durch eine sehr geordnete Struktur aus. In der REM-Aufnahme eines 570 nm dicken Filmes, der auf den in der Fig. 12 gezeigten Puffer-/Deckschichtaufbau aufgedampft wird, erkennt man deutlich die Übernahme der Morphologie des Magnesiumoxids (Fig. 13). Genauer zeigt die Fig. 13 die Oberfläche der Probe aus Fig. 12 nach der Bedampfung mit YBCO.

Bei einem Vergleich der jeweiligen Maßstäbe Fällt jedoch auf. daß die YBCO-Kristallite bei weitem größer als die des Magnesiumoxids sind, letztere also teilweise überwachsen werden. Im Gegensatz zu den HTSL-Schichten auf YSZ-, CeO₂ und einschichtigem MgO sind allerdings im Bild kaum senkrechte Orientierungen von a-Achsen zu erkennen, sondern es wird eine gleichförmige c-Achsen-Textur festgestellt. Die vollzogene Heteroepitaxie wird besonders deutlich in (103)-Polfiguren. Diese werden bevorzugt, da sie wegen der maximalen Intensität der Reflexe eine optimale Bestimmung von Orientierung und Halbwertsbreite erlauben. Die Polfigur, die zu dem in der Fig. 13 gezeigten Film als Oberfläche des Schichtmaterials gehört, ist in der Fig. 14 dargestellt.

Die Fig. 14 zeigt eine YBCO-{103}-Polfigur der Probe, die in den Fig. 12 und 13 behandelt ist. Eingezeichnet sind die Richtungen der a-Achsen (*) sowie der c-Achse (x). Zusätzlich sind die Lagen der a-Achsen (*) sowie der c-Achse (x) eingezeichnet, welche aus (200)- und (005)-Polfiguren ermittelt wurden. Es ergibt sich eine c-Achsen-Verkippung von 23,7° sowie eine (103)-Halbwertsbreite von 11°, während die entsprechenden Werte für die Pufferschicht β = 25,3° und FWHM = 12° sind.

Diese Polfiguren bestätigen eindrucksvoll das cube-on-cube-Wachstum von YBCO auf MgO und demonstrieren, daß sich die Textur gegenüber der Pufferschicht sogar verbessert. Die induktive Messungen von Sprungtemperatur und j_{c} ergeben für diese Probe Werte von 85,4 K bzw. 1,39 x 10⁵ A/cm². Um einen Vergleich anstellen zu können, wurden parallel zu den ISD-Proben auch MgO-Einkristalle bedampft. Hier beträgt j_{c} über 2 x 10⁶ A/cm² und T_{c} maximal 88 K. Die bislang besten Ergebnisse bei ISD liefert eine Probe mit T_{c} = 85,6 K und j_{c} = 2,80 x 10⁵ A/cm², wobei β = 18,5° und FWHM = 16° ist. Die Herstellung dieser Probe war identisch mit der in den Fig. 12 und 13 gezeigten Probe, mit der Ausnahme, daß bei der Deposition der ersten MgO-Schicht Substrattemperatur (45 °C) und α (15°) unterschiedlich waren. Die kristallographischen Resultate für die MgO-Schichten sind β = 19° und FWHM = 22°.

Vorrichtungs- und verfahrensmäßig sind somit jeweils für sich oder in Kombination folgende Merkmale und Eigenschaften bedeutsam: Aufdampfwinkel α₁ der Pufferschicht und ggf. α₂ bis αₙ der Deckschichten 2 bis n, Drucküberhöhung im Aufdampfbereich oder Schichtbildungsbereich nahe dem Substrat, keine Beschränkung auf Metalloxide, speziell biaxial texturierte MgO Schichten, speziell biaxial texturierte CeO2 Schichten. Deposition auf ein bewegtes Substrat, simultanes Aufbringen mehrerer Schichten auf ein Band mit einer Aufdampfquelle, simultanes Aufbringen von Puffer- und Deckschicht(en) und Supraleiter.

Für die auf der Pufferschicht angeordneten Deckschichten gilt insbesondere, daß sie bei höherer Temperatur und niedrigerer Rate aufgedampft werden können, damit sie epitaktisch aufwachsen, und/oder daß die Kippwinkel α₂ bis αₙ der 2 bis n Deckschichten 13 so gewählt werdcn, daß die Poren in der Pufferschicht 11 geschlossen werden. Bei einer MgO-Pufferschicht können speziell ein oder vorzugsweise zwei Deckschichten aus MgO vorgesehen sein.

Die Erfindung wurde vorstehend anhand einiger exemplarischer Ausführungsformen näher beschrieben, wobei auf die Zeichnung Bezug genommen wurde, in der gleiche oder gleichartige Teile und Komponenten durch alle Figuren hindurch mit denselben Bczugszeichen versehen sind. Die vorstehend näher dargelegten exemplarischen Ausführungsformen stellen jedoch keine Beschränkung der Erfindung darauf dar.

## Patentansprüche

1. Schichtsystem, insbesondere eines Hochtemperatursupraleiters, umfassend:
a) ein polykristallines oder amorphes Substrat (4);
b) eine auf dem Substrat angeordnete, biaxial texturierte Pufferschicht (11);
c) wenigstens eine auf der Pufferschicht (11) angeordnete, biaxial texturierte Deckschicht (13);
d) eine auf der äußersten der wenigstens einen Deckschicht (13) angeordnete orientierte oxidische Dünnschicht (14); wobei
e) die genannte biaxial texturierte Deckschicht (13) eine von der Pufferschicht (11) unterschiedliche Morphologie aufweist, um die Qualität der oxidischen Dünnschicht (14) zu verbessern.

2. Schichtsystem nach Anspruch 1, wobei die Pufferschicht (11) eine Facettierung aufweist.

3. Schichtsystem nach Anspruch 1 oder 2, wobei die biaxiale Textur der Kristallite der Pufferschicht (11) und die unterschiedliche Morphologie der Deckschicht (13) dadurch herstellbar ist, dass das Material für die Pufferschicht (11) unter einem Winkel α₁ ≠ 0° zur Normalen auf der Substratoberfläche auf letztere aufgedampft wird, und das Material für die Deckschicht (13) unter Depositionsbedingungen aufgedampft wird, die verschieden sind von denen, unter denen die Pufferschicht (11) aufgebracht wurde, insbesondere unter anderem Druck, anderer Temperatur, anderer Rate und/oder anderem Winkel α₂ ≠ α₁ vorzugsweise α₂ < α₁, bevorzugt α₂ = 0° zur Normalen auf der Substratoberfläche.

4. Schichtsystem nach einem der Ansprüche 1 bis 3, wobei die orientierte Dünnschicht (14) eine oxidische oder metallische Dünnschicht (14) und/oder eine technische Funktionsschicht ist, vorzugsweise eine YBCO-Schicht, eine ferromagnetische Schicht, einschließlich einer ferromagnetischen Schicht mit sog. "Giant Magneto Resistance", oder eine ferroelektrische Schicht.

5. Schichtsystem nach einem der Ansprüche 1 bis 4 wobei eine Mehrzahl von orientierten Dünnschichten (14) übereinander über der wenigstens einen Deckschicht (13) liegen.

6. Schichtsystem nach einem der vorhergehenden Ansprüche, wobei die Pufferschicht (11) und/oder wenigstens eine Deckschicht (13) Oxidmaterial, einschließlich MgO, CeO_{2,} Y₂O₃ stabilisiertes Zirkonoxid (YSZ), enthalten/enthält oder zumindest weitgehend aus diesen Materialien bestehen/besteht.

7. Schichtsystem nach einem der vorhergehenden Ansprüche, wobei das Substrat (4) eine der orientierten Dünnschicht (14) zugewandte, insbesondere polierte und/oder hitzebeständige Metall- oder Metallegierungsoberfläche mit amorpher oder polykristalliner Struktur aufweist.

8. Schichtsystem nach Anspruch 7, wobei das Substrat (4) selbst und/oder die Oberfläche thermisch oxidiertes Silizium, eine Nickelbasislegierung, wie Hastelloy C®, partiell Y₂O₃ stabilisiertes ZrO₂ (PSZ), hitzebeständigen Edelstahl, Platin und/oder Al₂O₃, jeweils in polykristalliner oder amorpher Form, enthalten/enthält.

9. Verfahren zum Herstellen eines Schichtsystems aufweisend die Schritte:
a) Aufbringen einer biaxial texturierten Pufferschicht (11) auf ein Substrat (4), indem Pufferschichtmaterial von Pufferschichtmaterialabgabeeinrichtungen unter einem Winkel α₁ ≠ 0° zur Normalen auf der Substratoberfläche auf letztere aufgedampft wird,
c) Aufbringen zumindest einer biaxial texturierten Deckschicht (13);
d) Aufbringen einer orientierten oxidischen Dünnschicht (14) auf der äußersten der Zumindest einem Deckschicht (13), wobei
e) die Deckschicht (13) bei höherer Temperatur und/oder anderem Druck und/oder anderer Rate und/oder anderem Winkel α₂ ≠ α₁ als die Pufferschicht (11)aufgebracht wird, um eine von der Pufferschicht (11) unterschiedliche Morphologie zu erreichen.

10. Verfahren nach Anspruch 9, wobei die Deckschicht unter einem Winkel α₂ < α₁, vorzugsweise α₂ = 0° zur Substratoberflächennormalen auf die Pufferschicht (11) aufgedampft wird und die Pufferschicht (11) eine Facettierung aufweist.

11. Verfahren nach Anspruch 9 oder Anspruch 10, wobei das Pufferschichtmaterial, und/oder das Deckschichtmaterial und/oder das Material für die orientierte Dünnschicht (14) durch thermisches Verdampfen, Elektronenstrahlverdampfung oder reaktives Verdampfen aufgebracht werden/wird.

12. Verfahren nach einem der Ansprüche 9 bis 11, wobei das Pufferschichtmaterial so aufgebracht wird, dass der Winkel α₁ größer, insbesondere geringfügig größer als ein Winkel β ist, den eine Kristallachse des Pufferschichtmaterials mit der Substratoberflächennormalen einschließt, wobei eine weitere Kristallachse des Pufferschichtmaterials parallel zur Substratoberfläche ist.

13. Verfahren nach einem der vorhergehenden Ansprüche, wobei in einem Schichtbildungsbereich oder in einem Bereich mit bereits gebildeter Schicht oder Teilschicht ein gegenüber den übrigen Vakuumbedingen erhöhter Druck erzeugt oder aufrechterhalten wird.

14. Verfahren nach einem der Ansprüche 9 bis 13, wobei das Substrat zumindest in einem ersten Schichtbildungsbereich so gegenüber der Horizontalen schräg angeordnet wird, dass Pufferschichtmaterial, das wenigstens ungefähr senkrecht zur Horizontalen von Pufferschichtmaterialabgabeeinrichtungen aufsteigt, in dem ersten Schichtbildungsbereich unter einem Winkel α₁ ≠ 0 zur Normalen auf der Substratoberfläche auf das Substrat gelangt.

15. Verfahren nach Anspruch 14, wobei das Substrat mit der Pufferschicht zumindest in einem zweiten Schichtbildungsbereich so gegenüber der Horizontalen schräg angeordnet wird, dass Deckschichtmaterial, das wenigstens ungefähr senkrecht zur Horizontalen von Deckschichtmaterialabgabeeinrichtungen aufsteigt, in dem zweiten Schichtbildungsbereich wenigstens annähernd unter dem Winkel α₂ ≠ α₁, insbesondere α₂ < α₁ , vorzugsweise α₂ = 0° zur Normalen auf der Substratoberfläche auf die Pufferschicht auf dem Substrat gelangt.

16. Verfahren nach einem der Ansprüche 9 bis 15, wobei das Substrat (4) zumindest in einem ersten Schichtbildungsbereich wenigstens annähernd parallel zur Horizontalen angeordnet wird und Pufferschichtmaterial relativ zum ersten Schichtbildungsbereich so aufgedampft wird, dass Pufferschichtmaterial, das schräg zur Horizontalen von Pufferschichtmaterialabgabeeinrichtungen aufsteigt, in dem ersten Schichtbildungsbereich unter einem Winkel α₁ ≠ 0 zur Normalen auf der Substratoberfläche auf das Substrat (4) gelangt.

17. Verfahren nach Anspruch 16, wobei das Deckschichtmaterial relativ zum zweiten Schichtbildungsbereich so aufgedampft wird, dass das Deckschichtmaterial, das schräg zur Horizontalen von den Deckschichtmaterialabgabeeinrichtungen aufsteigt, in dem zweiten Schichtbildungsbereich wenigstens ungefähr unter dem Winkel α₂ ≠ α₁, insbesondere α₂ < α₁ vorzugsweise α₂ = 0° zur Normalen auf der Substratoberfläche auf die Pufferschicht (11) auf das Substrat (4) gelangt.

18. Verfahren nach einem der vorhergehenden Ansprüche, wobei ein band- oder kabelförmiges Substratmaterial kontinuierlich gefördert wird, oder ein Substrat (4) beweglich angeordnet ist.

19. Verfahren nach Anspruch 18, wobei ein oder mehrere Schichtbildungsbereiche jeweils mehrfach durchlaufen werden und/oder mehrere Schichtbildungsbereiche nacheinander durchlaufen werden.

## Claims

1. Layer system, in particular of a high temperature superconductor, comprising:
a) a polycrystalline or amorphous substrate (4);
b) a biaxially textured buffer layer (11) arranged on the substrate;
c) at least one biaxially textured cover layer (13) arranged on the buffer layer (11);
d) an oriented oxidic thin layer (14) arranged on the outermost of the at least one cover layer (13); wherein
e) said biaxially textured cover layer (13) comprises a different morphology than the buffer layer (11) to improve the quality of the oxidic thin layer (14).

2. Layer system according to claim 1, wherein the buffer layer (11) comprises facets.

3. Layer system according to claim 1 or 2, wherein the biaxial texture of the crystallites of the buffer layer (11) and the different morphology of the cover layer (13) can be produced by vapor deposition of the material for the buffer layer (11) with an angle α₁ ≠ 0° with respect to the normal of the substrate surface onto the latter, and by vapor deposition of the materials for the cover layer (13) with deposition conditions different from the conditions for depositing the buffer layer (11), in particular with a different pressure, a different temperature, a different rate and/or a different angle α₂ ≠ α₁, preferably α₂ < α₁, preferably α₂ = 0° with respect to the normal of the substrate surface.

4. Layer system according to one of the claims 1 to 3, wherein the oriented thin layer (14) is an oxidic or metallic thin layer (14) and/or a technical functional layer, preferably an YBCO-layer, a ferromagnetic layer, including a ferromagnetic layer with so-called "giant magneto resistance" or a ferroelectric layer.

5. Layer system according to one of the claims 1 to 4, wherein a plurality of oriented thin layers (14) are arranged above each other on top of the at least one cover layer (13).

6. Layer system according to any of the preceding claims, wherein the buffer layer (11) and/or the at least one cover layer (13) comprise/comprises oxide material, including MgO, CeO₂, Y₂O₃ stabilized zircon oxide (YSZ), or consist/consists at least to a great extent of these materials.

7. Layer system according to any of the preceding claims, wherein the substrate (4) comprises a metal or a metal alloy surface directed to the oriented thin layer (14) with amorphous or polycrystalline structure in particular being polished and/or heat resistant.

8. Layer system according to claim 7, wherein the substrate (4) itself and/or the surface comprise/comprises thermally oxidized silicon, a nickel based alloy such as Hastelloy C®, partially Y₂O₃ stabilized ZrO₂ (PSZ), heat resistant stainless steel, platinum and/or Al₂O₃, each in polycrystalline or amorphous form.

9. Method for manufacturing of a layer system comprising the steps of:
a) depositing a biaxially textured buffer layer (11) onto a substrate (4) by vapor deposition of a buffer layer material from buffer layer material release devices under an angle α₁ ≠ 0° with respect to the normal on the substrate surface onto the latter,
b) depositing at least one biaxially textured cover layer (13);
c) depositing an oriented oxidic thin layer (14) onto the outermost of the at least one cover layer (13), wherein
d) the cover layer (13) is deposited at a higher temperature and/or a different pressure and/or a different rate and/or a different angle α₂ ≠ α₁ than the buffer layer (11) to obtain a different morphology than the buffer layer (11).

10. Method according to claim 9, wherein the cover layer is vapor deposited under an angle α₂ < α₁, preferably α₂ = 0° with respect to the substrate surface normal onto the buffer layer (11) and wherein the buffer layer (11) comprises facets.

11. Method according to claim 9 or claim 10, wherein the buffer layer material and/or the cover layer material and/or the material for the oriented thin layer (14) are deposited by thermal evaporation, electron beam evaporation or reactive evaporation.

12. Method according to one of the claims 9 to 11, wherein the buffer layer material is deposited such that the angle α₁ is greater, particularly slightly greater than an angle β which is a crystalline axis of the buffer layer material with respect to the substrate surface normal, wherein a further crystalline axis of the buffer layer material is parallel to the substrate surface.

13. Method according to one of the preceding claims, wherein an increased pressure is created or maintained in a layer forming region or in a region of an already formed layer or partial layer compared to the other vacuum conditions.

14. Method according to one of the claims 9 to 13, wherein the substrate is at least in a first layer forming region inclined with respect to the horizontal line such that buffer layer material ascending approximately perpendicularly to the horizontal line from the buffer layer release devices reaches the substrate in the first layer forming region with an angle α₁ ≠ 0° with respect to the substrate surface normal.

15. Method according to claim 14, wherein the substrate with the buffer layer is at least in a second layer forming region inclined with respect to the horizontal line so that cover layer material which ascends at least approximately perpendicularly with respect to the horizontal line from the cover layer material release devices reaches the buffer layer on the substrate in the second layer forming region at least approximately under an angle α₂ ≠ α₁, in particular α₂ < α₁, preferably α₂ = 0° with respect to the substrate surface normal.

16. Method according to one of the claims 9 to 15, wherein the substrate (4) is at least in a first layer forming region at least approximately parallel arranged with respect to the horizontal line and wherein buffer layer material is relatively to the first layer forming region vapor deposited such that buffer layer material which ascends inclined with respect to the horizontal line from the buffer layer material release devices, reaches the substrate (4) in the first layer forming region under an angle α₁ ≠ 0° with respect to the substrate surface normal.

17. Method according to claim 16, wherein the cover layer material is relatively to the second layer forming region vapor deposited such that the cover layer material which ascends inclined with respect to the horizontal line from the cover layer material release devices reaches the buffer layer (11) on the substrate (4) in the second layer forming region at least approximately under the angle α₂ ≠ α₁, in particular α₂ < α₁, preferably α₂ = 0° with respect to the substrate surface normal.

18. Method according to one of the preceding claims, wherein a band or cable-shaped substrate material is continuously conveyed or wherein a substrate (4) is moveably arranged.

19. Method according to claim 18, wherein one or more layer forming regions are each passed several times and/or wherein several layer forming regions are passed one after the other.

## Revendications

1. Système stratifié, notamment d'un supraconducteur à haute température, comprenant:
a) un substrat polycristallin ou amorphe (4);
b) une couche tampon à texture biaxiale (11) disposée sur le substrat;
c) au moins une couche de revêtement à texture biaxiale (13), disposée sur la couche tampon (11);
d) une couche mince d'oxyde orientée (14) disposée sur la plus extérieure de la au moins une couche de revêtement (13);
e) ladite couche de revêtement à texture biaxiale possédant une morphologie qui diffère de la couche tampon (11), pour améliorer la qualité de la couche mince d'oxyde (14).

2. Système stratifié selon la revendication 1, dans lequel la couche tampon (11) possède un facettage.

3. Système stratifié selon la revendication 1 ou 2, dans lequel la texture biaxiale des cristallites de la couche tampon (11) et la morphologie différente de la couche de revêtement (13) peuvent être fabriqués de telle sorte que le matériau pour la couche tampon (11) est déposée par évaporation sur la surface du substrat sous un angle α₁ ≠ 0° par rapport à la normale à cette surface, et qu'on dépose par évaporation le matériau pour la couche de revêtement (13) dans des conditions de dépôt, qui sont différentes de celles, dans lesquelles la couche tampon (11) a été déposée, notamment sous une autre pression, sous une autre température, sous une autre cadence et/ou sous un autre angle α₂ ≠ α₁, de préférence α₂ ≠ α₁, et de façon préférentielle α₂ = 0° par rapport à la normale à la surface du substrat.

4. Système stratifié selon l'une dés revendications 1 à 3, dans lequel la couche mince orientée (14) possède une couche mince d'oxyde ou métallique (14) et/ou est une couche fonctionnelle technique, de préférence une couche de YBCO, une couche ferromagnétique, y compris une couche ferromagnétique comportant ce qu'on appelle une "Giant Magneto Resistance" ou une couche ferroélectrique.

5. Système stratifié selon l'une des revendications 1 à 4, dans lequel une multiplicité de couches minces orientées (14) sont situées les unes sur les autres au-dessus de la au moins une couche de revêtement (13).

6. Système stratifié selon l'une des revendications précédentes, dans lequel la couche tampon (11) et/ou au moins une couche de revêtement (13) contiennent par un matériau formé d'oxyde, y compris Mc0, CeO₂, CoO₂, Y₂O₃, de l'oxyde de zirconium stabilisé (YSZ), ou est/sont constituée(s) dans une large mesure avec ces matériaux.

7. Système stratifié selon l'une des revendications précédentes, dans lequel le substrat (4) possède une surface métallique ou de métallisation qui est tournée vers la couche mince orientée (14) et notamment est polie et/ou est résistante à la chaleur et possède une structure amorphe ou polycristalline.

8. Système stratifié selon la revendication 7, dans lequel le substrat (4) lui-même ou la surface contient un alliage à base de nickel, comme par exemple du Hastolloy C®, du ZrO₂ stabilisé partiellement par du Y₂O₃ (PSZ), un acier spécial résistant à la chaleur, du platine et/ou du Al₂O₃, respectivement sous forme polycristalline ou amorphe.

9. Procédé pour fabriquer un système stratifié comportant les étapes consistant à:
a) déposer une couche tampon à texture biaxiale (11) sur un substrat (4), en déposant par évaporation un matériau de la couche tampon au moyen de dispositifs de délivrance du matériau de la couche tampon sous un angle α₁ ≠ 0° par rapport à la normale à la surface du substrat,
c) déposer au moins une couche de revêtement à texture biaxiale (13);
d) déposer une couche mince d'oxyde orientée (14) sur la plus extérieure de la au moins une couche de revêtement (14);
e) la couche revêtement (13) étant déposée à une température plus élevée et/ou sous une autre pression et/ou à une autre cadence et/ou sous un autre angle α₂ ≠ α₁ que la couche tampon (11) pour l'obtention d'une morphologie qui diffère de celle de la couche tampon (11).

10. Procédé selon la revendication 9, selon lequel on dépose par évaporation la couche de revêtement sous un angle α₂ < α₁, de préférence α₂ = 0° par rapport à la normale à la surface du substrat, sur la couche tampon (11), et la couche tampon (11) possède un facettage.

11. Procédé selon la revendication 9 ou la revendication 10, selon lequel le matériau de la couche tampon et/ou le matériau de la couche de revêtement et/ou le matériau pour la couche mince orientée (14) est/sont déposé(s) par évaporation thermique, évaporation utilisant un faisceau d'électrons ou évaporation réactive.

12. Procédé selon l'une des revendications 9 à 11, selon lequel le matériau de la couche tampon est déposé de telle sorte que l'angle α₁ est supérieur, et notamment légèrement supérieur à un angle β, que fait un axe du cristal du matériau de la couche tampon avec la normale à la surface du substrat, un autre axe du cristal du matériau de la couche tampon étant parallèle à la surface du substrat.

13. Procédé selon l'une des revendications précédentes, selon lequel on produit ou on maintient une pression accrue par rapport aux conditions usuelles de vide dans une zone de formation de couche ou dans une zone dans laquelle une couche ou une couche partielle est déjà formée.

14. Procédé selon l'une des revendications 9 à 13, selon lequel on dispose le substrat, au moins dans une première zone de formation de couche, obliquement par rapport à l'horizontale de telle sorte que le matériau de la couche tampon, qui s'élève au moins approximativement perpendiculairement par rapport à l'horizontale à partir de dispositifs de délivrance du matériau de la couche tampon, atteint la substrat dans la première zone de formation de couche sous un angle α₁ ≠ 0 par rapport à la normale à la surface du substrat.

15. Procédé selon la revendication 14, selon lequel le substrat est équipé de la couche tampon au moins dans une seconde zone de formation de couche et disposé obliquement par rapport à l'horizontale de telle sorte que le matériau de la couche de revêtement, qui s'élève au moins approximativement perpendiculairement à l'horizontale à partir des dispositifs de délivrance du matériau de la couche de revêtement, parvient sur la couche tampon située sur le substrat dans la seconde zone de formation de couche au moins approximativement sous l'angle α₂ ≠ α₁, notamment α₂ < α₁, de préférence α₂ = 0° par rapport à la normale à la surface du substrat sur la couche tampon.

16. Procédé selon l'une des revendications 9 à 15, selon lequel le substrat (4) est disposé au moins dans une première zone de formation de couche, au moins approximativement parallèlement à l'horizontale et le matériau de la couche tampon est déposé par évaporation par rapport à la première zone de formation de couche de telle sorte que le matériau de la couche tampon, qui s'élève obliquement par rapport à l'horizontale à partir des dispositifs de délivrance du matériau de la couche tampon, parvient sur le substrat (4) dans la première zone de formation de couche sous un angle α₁ ≠ 0 par rapport à la normale à la surface du substrat.

17. Procédé selon la revendication 16, selon lequel on dépose par évaporation le matériau de la couche de revêtement par rapport à la seconde zone de formation de couche de telle sorte que le matériau de la couche de revêtement, qui s'élève obliquement par rapport à l'horizontale à partir du dispositif de délivrance du matériau de la couche de revêtement parvient sur la couche tampon (11) située sur le substrat (4) au moins approximativement sous l'angle α₂ ≠α₁, notamment α₂ < α₁ et de préférence α₂ = 0° par rapport à la normale à la surface du substrat.

18. Procédé selon l'une des revendications précédentes, selon lequel un matériau formant substrat en forme de bande ou de câble est entraîné continûment, ou un substrat (14) est disposé de manière à être mobile.

19. Procédé selon la revendication 18, selon lequel une ou plusieurs zones de formation de couche sont parcourues respectivement de façon multiple et/ou plusieurs zones de formation de couche sont parcourues successivement.
